# EUROPÄISCHE PATENTSCHRIFT

(11) **EP 3 212 727 B1**
(45) Veröffentlichungstag und Bekanntmachung des Hinweises auf die Patenterteilung: **05.03.2025**
(21) Anmeldenummer: 15786881.1
(22) Anmeldetag: 15.10.2015
(51) Int. Cl.: C09J 153/02, C08L 53/02, H01L 23/26, C09J 11/04, C09J 163/00, C09J 7/10, C09J 11/06, C08G 59/24

(54) **KLEBEMASSEN MIT AKTIVIERBAREN GETTERMATERIALIEN**
ADHESIVE COMPOUNDS CONTAINING GETTER MATERIALS THAT CAN BE ACTIVATED
MATIÈRES ADHÉSIVES À MATÉRIAUX GETTER ACTIVABLES

(30) Priorität: 29.10.2014 DE 102014222038
(43) Veröffentlichungstag der Anmeldung: 06.09.2017
(73) Patentinhaber: tesa SE, 22848 Norderstedt (DE)
(72) Erfinder: SCHUH, Christian, 22767 Hamburg (DE); KEITE-TELGENBÜSCHER, Klaus, 22529 Hamburg (DE); GÄBERT, Chris, 02627 Weißenburg (DE)
(74) Vertreter: tesa SE
(86) Internationale Anmeldenummer: PCT/EP2015/073898
(87) Internationale Veröffentlichungsnummer: WO 2016/066435

(56) Entgegenhaltungen:
- WO-A1-2015/154947
- WO-A2-2004/009720
- WO-A2-2005/118679
- DE-A1- 102012 211 335
- US-A- 5 304 419
- US-A- 6 121 354
- US-A1- 2010 159 238

## Beschreibung

Die vorliegende Erfindung betrifft eine Klebemasse enthaltend ein Gettermaterial sowie optional ein Lösungsmittel, ein Klebeband mit dieser Klebemasse, die Verwendung einer solchen Klebemasse sowie eines solchen Klebebandes und ein Verfahren zum Applizieren der Klebemasse beziehungsweise des Klebebandes. Des Weiteren betrifft die Erfindung ein Klebeband mit dieser Klebemasse sowie die Verwendung einer solchen Klebemasse.

Solche Klebemassen sind allgemein bekannt.

US 2010/159238 beschreibt eine mehrschichtige Klebstoffzusammensetzung, die eine erste Schicht, hergestellt aus einer ersten Zusammensetzung, die einen Teil A und einen Teil B umfasst, wobei Teil a einen Weichmacher, ein Vernetzungsmittel und einen Haftvermittler umfasst, wobei Teil B einen Feuchtigkeitsschutz und einen Abriebschutz umfasst und wobei die erste Schicht im Wesentlichen sulfidfrei ist.

DE10 2012 211 335 betrifft ein Verfahren zum Schutz einer auf einem Substrat angeordneten elektronischen Anordnung umfassend organische Bestandteile, wobei eine Abdeckung derart auf die elektronische Anordnung aufgebracht wird, dass die elektronische Anordnung zumindest teilweise durch die Abdeckung überdeckt wird, wobei die Abdeckung zumindest teilflächig auf dem Substrat und/oder auf der elektronischen Anordnung verklebt wird, wobei die Verklebung mittels zumindest einer Schicht einer Klebemasse in einem Klebeband bewirkt wird, wobei die Klebemasse ein zur Sorption mindestens einer permeationsfähigen Substanz befähigtes Gettermaterial umfasst, wobei das Gettermaterial zu einem Anteil von nicht mehr als 2 Gew.-% bezogen auf die Klebemasse mit dem Gettermaterial, in der Klebemasse vorliegt.

US 5304419 offenbart ein hermetisch abgedichtetes Gehäuse, in dem sich ein elektronisches Gerät befindet und dessen Innenfläche zumindest teilweise mit einer Beschichtung aus einem druckempfindlichen Klebstoff versehen ist, der 4 bis 40 Vol.-% eines feinteiligen, festen Trockenmittels mit einer durchschnittlichen Partikelgröße von 0,2 bis 100 µm enthält, wobei die Beschichtung eine Dicke von 1 bis 25 mm aufweist und wirksam ist, um eine Umgebung innerhalb des Gehäuses im Wesentlichen feuchtigkeitsfrei und im Wesentlichen frei von freien Feststoffpartikel zu halten.

US 6121354 beansprucht ein heißschmelzendes Einkomponenten-Dichtmittel, bestehend aus einem Styrolblockcopolymer, einem feuchtigkeitshärtbarem silysierten Polyurethan-Präpolymer, einem aromatischen Klebharz, einem polaren Klebharz, einem Polyethylenwachs und einem organofunktionellem Silan.

WO 2004/009720 betrifft eine umwandelbare Haftklebstoffzusammensetzung, bestehend aus 15 bis 80 Gew.-% eines Polymers mit einem Erweichungspunkt von mehr als 60 °C, 20 bis 85 Gew.-% eines polymerisierbaren Harzes mit einem Erweichungspunkt von weniger als 30 °C und einem latenten Initiator in einer ausreichenden Menge, um die Reaktion zwischen dem Polymer und dem Harz hervorzurufen und optionalen einem Vernetzungsmittel.

WO 201515947 beschreibt einen transluzenten, mehrphasigen Klebstoff enthaltend mindestens eine kontinuierliche Phase sowie dispers verteilte Domänen, wobei die zumindest eine kontinuierliche Phase einen Brechungsindex von mehr als 1,45 und eine Permeationsrate für Wasserdampf von weniger als 100 g/m² aufweist und die dispersen Domänen in einem Gewichtsanteil von nicht mehr als 10 Gew.-% in der Klebemasse enthalten sind, wobei die dispersen Domänen polymerer Natur sind, eine WVTR von weniger als 100 g/m² und einen Brechungsindex von weniger als 1,45 aufweisen.

WO 2005/118679 offenbart eine Kleb- oder Dichtstoffzusammensetzung, die ein vernetzbares Polymer, einen Vernetzungskatalysator für das Polymer, einen Rheologieregler und einen Wasserfänger umfasst, wobei das vernetzbare Polymer Silyil-Endgruppen aufweist und ein äquivalentes Molekulargewicht zwischen 10.000 und 20.000 aufweist.

Das in der Klebemasse enthaltene Gettermaterial ist in der Lage, permeationsfähige Substanzen wie zum Beispiel Wasser, Sauerstoff, niedermolekulare Kohlenwasserstoffe oder flüchtige organische Verbindungen, die in die Klebemasse eindringen, abzufangen. Solche Klebemassen dienen zum Beispiel dazu, Gegenstände, die vor Wasser geschützt werden sollen, abzukapseln. Die permeationsfähige Substanz ist in diesem Fall Wasser. Ein besonders wichtiges Einsatzgebiet für solche Getter sind (opto)elektronische Anordnungen. (Opto-)elektronische Anordnungen werden immer häufiger in kommerziellen Produkten verwendet. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren wie Hochdruck, Tiefdruck, Siebdruck, Flachdruck oder wie auch so genanntes "non impact printing" wie etwa Thermotransferdruck Tintenstrahldruck oder Digitaldruck. Vielfach werden aber auch Vakuumverfahren wie zum Beispiel Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet, wobei die Strukturierung in der Regel durch Masken erfolgt.

Als Beispiele für bereits kommerzielle oder in ihrem Marktpotential interessante (opto-)elektronische Anwendungen seien hier elektrophoretische oder elektrochrome Aufbauten oder Displays, organische oder polymere Leuchtdioden (OLEDs oder PLEDs) in Anzeige-und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und Selen, Perowskitsolarzellen, organische Feldeffekt-Transistoren, organische Schaltelemente, organische optische Verstärker, organische Laserdioden, organische oder anorganische Sensoren oder auch organisch- oder anorganischbasierte RFID-Transponder angeführt.

Weitere Anwendungen verkapselnder Klebebänder sind im Bereich der Batterietechnik bekannt, insbesondere im Bereich der flexiblen Mikrobatterien und Dünnschichtbatterien, ganz besonders solchen umfassend lithiumhaltige Kathoden, Anoden oder Elektrolyte.

Demgemäß wird in dieser Schrift unter einer organischen (opto-)elektronischen Anordnung eine elektronische Anordnung verstanden, die zumindest einen elektronisch funktionalen, zumindest teilweise organischen Bestandteil umfasst - zum Beispiel metallorganische Verbindungen - oder deren elektronisch funktionaler Aufbau eine Dicke von weniger als 20 µm aufweist.

Als technische Herausforderung für die Realisierung ausreichender Lebensdauer und Funktion von (opto-)elektronischen Anordnungen im Bereich der anorganischen und/oder organischen (Opto-)Elektronik, ganz besonders aber im Bereich der organischen (Opto-)Elektronik ist ein Schutz der darin enthaltenen Komponenten vor Permeaten zu sehen. Permeate können eine Vielzahl von niedermolekularen organischen oder anorganischen Verbindungen sein, insbesondere Wasserdampf und Sauerstoff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasser oder Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So können sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Um eine möglichst gute Versiegelung zu erzielen, werden spezielle Barriereklebemassen (auch als wasserdampfsperrende Klebemassen bezeichnet) verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeaten unter stationären Bedingungen bei bestimmter Permeationsweglänge, Partialdruck und Temperatur. Die Permeabilität P ist das Produkt aus Diffusions-Term D und Löslichkeits-Term S: P = D * S

Der Löslichkeitsterm S beschreibt vorwiegend die Affinität der Barriereklebemasse zum Permeaten. Im Fall von Wasserdampf wird beispielsweise ein geringer Wert für S von hydrophoben Materialen erreicht. Der Diffusionsterm D ist ein Maß für die Beweglichkeit des Permeaten im Barrierematerial und ist direkt abhängig von Eigenschaften wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent, und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ansätze, um die Barrierewirkung einer Klebemasse zu erhöhen, müssen die beiden Parameter D und S insbesondere berücksichtigen im Hinblick auf den Einfluss auf die Durchlässigkeit von Wasserdampf und Sauerstoff. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Ein geringer Löslichkeits-Term S allein ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeits-Term), weisen aber durch ihre frei drehbare Si-O-Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeits-Term S und Diffusions-Term D notwendig.

Beschrieben sind weiterhin Barriereklebemassen auf der Basis von Styrolblockcopolymeren und möglichst hydrierten Harzen (siehe DE 10 2008 047 964 A1). Hier werden auch Permeationswerte (WVTR) von weit verbreiteten Klebstoffsystemen angegeben (gemessen bei 37.5°C und 90% relativer Feuchte). Typische Haftklebemassen auf Acrylatbasis liegen im Bereich zwischen 100 g/m² d und 1000 g/m² d. Silikonhaftklebemassen haben aufgrund der hohen Beweglichkeit der Ketten noch höhere Permeationswerte für Wasser von über 1000 g/m² d. Werden Styrolblockcopolymere als Elastomerkomponente verwendet, so werden für nicht oder nicht-vollständig hydrierteSysteme WVTR-Werte im Bereich von 50 - 100 g/m² d und für hydrierte Systeme (zum Beispiel SEBS) Werte unter 50 g/m² d erreicht. Besonders niedrige WVTR-Werte von unter 15 g/m² d werden sowohl mit reinen Poly(isobutylen)elastomeren oder Blockcopolymeren aus Styrol und Isobutylen erreicht.

Eine Möglichkeit, die Barrierewirkung noch zu verbessern, ist der Einsatz von Stoffen, die mit den eindringenden Substanzen, den sogenannten permeationsfähigen Substanzen, wie zum Beispiel Wasser oder Sauerstoff reagieren. In die (opto-)elektronische Anordnung eindringende permeationsfähige Substanzen wie Sauerstoff oder Wasserdampf werden dann an diese Stoffe chemisch oder physikalisch, bevorzugt chemisch gebunden und erhöhen somit die Durchbruchszeit ("lag-time"). Diese Stoffe werden in der Literatur als "Getter", "scavenger", "desiccants" oder "absorber" bezeichnet. Im Folgenden wird der Ausdruck Getter verwendet. Ein Getter oder Gettermaterial ist ein Material, das zur Sorption mindestens einer permeationsfähigen Substanz in der Lage ist.

Gettermaterialien sind beispielsweise Salze wie Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Kieselsäuren (zum Beispiel Silica Gel), Aluminiumsulfat, Calciumsulfat, Kupfersulfat, Bariumsulfat, Magnesiumsulfat, Lithiumsulfat, Natriumsulfat, Cobaltsulfat, Titansulfat, Natriumdithionit, Natriumcarbonat, Kaliumdisulfit, Kaliumcarbonat, Magnesiumcarbonat, Titandioxid, Kieselgur, Zeolithe, Schichtsilikate wie Montmorillonit und Bentonit, Metalloxide wie Bariumoxid, Calciumoxid, Eisenoxid, Magnesiumoxid, Natriumoxid, Kaliumoxid,Strontiumoxid, Aluminiumoxid (aktiviertes Alumina); weiter Kohlenstoffnanoröhrchen, Aktivkohle, Phosphorpentoxid und Silane; leicht oxidierbare Metalle wie beispielsweise Eisen, Calcium, Natrium und Magnesium; Metallhydride wie beispielsweise Calciumhydrid, Bariumhydrid, Strontiumhydrid, Natriumhydrid und Lithiumaluminiumhydrid; Hydroxide wie Kaliumhydroxid und Natriumhydroxid, Metallkomplexe wie zum Beispiel Aluminiumacetylacetonat; des Weiteren organische Absorber, beispielsweise Polyolefin-Copolymere, Polyamid-Copolymere, PET-Copolyester, Anhydride von einfachen und mehrfachen Carbonsäuren wie Essigsäureanhydrid, Propionsäureanhydrid, Buttersäureanhydrid oder Methyltetrahydrophtalsäureanhydrid, Isocyanate oder weitere auf Hybridpolymeren basierte Absorber, die meist in Kombination mit Katalysatoren wie beispielsweise Cobalt verwendet werden; weitere organische Absorber wie etwa schwach vernetzte Polyacrylsäure, Polyvinylalkohol, Ascorbate, Glucose, Gallussäure oder ungesättigte Fette und Öle.

Die Gettermaterialien werden ihrer Funktion entsprechend bevorzugt als im Wesentlichen von Permeaten freie Materialien eingesetzt, zum Beispiel wasserfrei. Dies unterscheidet Gettermaterialien von ähnlichen Materialien, die als Füllstoff eingesetzt werden. So wird Silica zum Beispiel in der Form von pyrogener Kieselsäure häufig als Füllstoff eingesetzt. Wird dieser Füllstoff jedoch wie üblich unter Umgebungsbedingungen gelagert, nimmt er bereits Wasser aus der Umgebung auf und ist nicht mehr in technisch nutzbarem Umfang als Gettermaterial funktionsfähig. Erst getrocknetes oder trocken gehaltenes Silica kann als Gettermaterial genutzt werden. Es ist jedoch auch möglich, bereits teilweise mit Permeaten komplexierte Materialien zu verwenden, beispielsweise CaSO₄*1/2H₂O (Calciumsulfat-Halbhydrat) oder teilhydrierte Kieselsäuren, die per Definition als Verbindungen der allgemeinen Formel (SiO₂)m*nH₂O vorliegen.

Unter Kieselsäuren werden, wie vorstehend beschrieben, Verbindungen der allgemeinen Formel (SiO₂)m*nH₂O verstanden. Es handelt sich dabei um durch nasschemische, thermische oder pyrogene Verfahren hergestelltes Siliciumdioxid. Insbesondere sind unter den Kieselsäuren Kieselgele beziehungsweise Silicagele, beispielsweise mit Kobalt-Verbindungen als Feuchteindikator imprägnierte Kieselgele (Blaugel), und pyrogene Kieselsäuren geeignete Gettermaterialien.

Unter "Sorption" wird der Vorgang der Aufnahme eines Stoffes oder mehrerer Stoffe durch einen anderen Stoff - erfindungsgemäß durch das Gettermaterial - verstanden. Der Getter ließe sich daher auch als "Sorbens" oder "Sorptionsmittel" bezeichnen. Die Sorption der permeationsfähigen Substanz(en) durch das Gettermaterial kann dabei beispielsweise durch Absorption oder Adsorption erfolgen, wobei Adsorption sowohl in Form von Chemisorption als auch von Physisorption auftreten kann.

Unter einer "permeationsfähigen Substanz" wird eine Substanz verstanden, die als gasförmiger oder flüssiger, gegebenenfalls auch als fester Stoff, in die zu schützende Klebemasse eindringen und diese nachfolgend durchdringen kann. Derartige Substanzen wurden vorstehend und werden nachstehend als "Permeate" bezeichnet. Die Permeate können aus der Klebemasse selbst oder aus der Umgebung, beispielsweise auch aus dem Trägermaterial eines mit der Klebemasse beschichteten Klebebandes stammen. Aus der Klebemasse beziehungsweise aus dem Klebeband selbst kommen häufig niedermolekulare organische Verbindungen wie Lösemittelreste, Restmonomere, Öle, Harzkomponenten, Weichmacher sowie Wasser. Aus der Umgebung stammen oft Wasser, flüchtige organische Verbindungen (VOCs), niedermolekulare Kohlenwasserstoffe und Sauerstoff.

Zum Beispiel für Wasser erfolgt die Bindung des eindringenden Wassers entweder physikalisch durch Adsorption typischerweise an Silica, Molekularsieben, Zeoliten oder Natriumsulfat. Chemisch wird Wasser über Alkoxysilane, Oxazolidine, Isocyanate, Bariumoxid, Phosphorpentoxid, Alkali- und Erdalkalioxide (wie beispielsweise Calciumoxid), metallisches Calcium oder Metallhydride gebunden (WO 2004/009720 A2).

Beschrieben als solche Getter sind in Klebmassen hauptsächlich anorganische Füllstoffe wie beispielsweise Calciumchlorid oder verschiedene Oxide (vergleiche US 5,304,419 A, EP 2 380 930 A1 oder US 6,936,131 A).

Auch organische Getter sind in Klebemassen beschrieben, so zum Beispiel in der EP 2 597 697 A1, in der polymere Alkoxysilane als Getter verwendet werden. Zahlreiche verschiedene Silane als Getter in Klebemassen werden in der WO 2014/001005 A1 genannt. Aus der großen Auswahl an Alkoxysilanen würde der Fachhmann zunächst leicht hydrolisierbare wie beispielsweise Methoxysilane auswählen. Besonders gute Aktivitäten erreicht man jedoch bei der Verkapselung von Aufbauten der organischen Elektronik, wenn die Alkoxygruppe eine Ethoxygruppe ist. Es hat sich gezeigt, dass überraschenderweise die im Vergleich zu Methoxysilanen unreaktiveren Ethoxysilane vor allen Dingen bei hohen Temperaturen die Permeation von Feuchtigkeit deutlich besser reduzieren. Dies ist unerwartet, da Methoxysilane normalerweise eine höhere Reaktivität aufweisen als die entsprechenden Ethoxysilane (vergleiche Wacker Produktbeschreibung 6085e/09.13 "GE-NIOSL^{®}", Seite 11 aus September 2013 (09.13)).

Schwierigkeiten bei derartigen Klebemassen oder Tapes aus solchen Klebemassen bestehen in der Lagerung und im Transport bis zum endgültigen Einsatz. Eine Klebemasse oder ein Tape, das einen Getter enthält, muss hermetisch versiegelt bis zur Anwendung gelagert und/oder transportiert werden. Eindringende Permeate wie insbesondere Feuchtigkeit werden vom Getter aufgenommen, wodurch dieser verbraucht wird und somit die Barriereeigenschaft reduziert wird. Dies ist gerade für Anwendungen in der Elektronik sehr nachteilig, da die Klebebänder meist zu Stanzlingen bei externen Convertern zugeschnitten werden und somit Kontakt zu Feuchtigkeit haben. Somit werden die Wasserfänger im Tape je nach Zeit, die der Converter zum Stanzen benötigt und vorhandener Luftfeuchtigkeit mal mehr, mal weniger verbraucht. Abgesehen von der Reduzierung der Getterfunktion, also von der Fähigkeit als Getter zu wirken - und in diesem Fall Wasser aufzunehmen -, ist somit auch keine eindeutige Aussage mehr darüber möglich, über welche Getterkapazität, das heißt über welche Fähigkeit zur Wasseraufnahme, die Klebemasse beziehungsweise das Klebeband nach erfolgter Applikation noch verfügt.

Der Erfindung lag daher die Aufgabe zugrunde, eine Klebemasse zur Verfügung zu stellen, die bis zur Applikation beim Anwender kurzzeitigen Kontakt mit Permeaten wie insbesondere Feuchtigkeit toleriert, ohne dass die Getterkapazität nennenswert beeinträchtigt wird.

Überraschenderweise wurde gefunden, dass diese Aufgabe durch eine Klebemasse wie sie in Anspruch 1 definiert ist, gelöst wird. Bevorzugte Ausführungsformen der vorliegenden Erfindung sind in den abhängigen Ansprüchen dargelegt.

Der vorliegenden Erfindung liegt entsprechend die Erkenntnis zugrunde, dass eine solche Klebemasse erhalten werden kann, wenn eine Klebemasse der eingangs genannten Art einen Katalysator für die Reaktion des Gettermaterials aus der Gruppe der Ethoxysilane mit einem Permeaten enthält, der mittels eines äußeren Stimulus aktivierbar ist. Die vorliegende Erfindung ist für Wasser als Permeat besonders gut geeignet.

Bei einer solchen Klebemasse kann die Getterfunktion aktiviert werden, wenn sie benötigt wird, das heißt insbesondere dann, wenn die Klebemasse appliziert ist und einen Gegenstand gegen das Permeat, zum Beispiel Wasserdampf, abdichten soll. Eine solche Klebemasse kann als "schaltbar" bezeichnet werden. Ihre permeatbindende Funktion, insbesondere wasserbindende Funktion, kann durch einen äußeren Stimulus oder Trigger "angeschaltet" werden, indem der Katalysator durch den äußeren Stimulus oder Trigger aktiviert wird. Während der Lagerung oder des Transportes der Klebemasse ist der Katalysator und damit die Getterfunktion noch nicht aktiviert beziehungsweise angeschaltet. Der Getter reagiert nicht oder nicht nennenswert mit dem Permeat, insbesondere mit Wasserdampf, und wird nicht verbraucht. Erst wenn die Klebemasse appliziert ist und tatsächlich einen Gegenstand gegen Wasserdampf abdichten und vor Eindringen von Wasserdampf schützen soll, wird der Getter aktiviert oder "angeschaltet" und nimmt seine Funktion auf.

Der Katalysator verändert die Geschwindigkeitskonstante für die Reaktion des Getters mit dem Permeaten, insbesondere Wasser(dampf). Eine Veränderung im Sinne der vorliegenden Erfindung ist gegeben, wenn die Geschwindigkeitskonstante mindestens um einen Faktor 5, bevorzugt 10, besonders bevorzugt mindestens um einen Faktor 50 erhöht wird.

Der Katalysator kann zum Beispiel eine latente Säure oder eine latente Base sein, das heißt, der Katalysator kann nach Aktivierung das chemische Milieu im Hinblick auf die Säure-Base-Eigenschaften verändern und damit eine Reaktion, deren Geschwindigkeit von diesem Milieu abhängig ist, beschleunigen. So ist die Abhängigkeit der Reaktionsgeschwindigkeit vom pH-Wert am Beispiel eines Silans im J. Org. Chem., Vol. 51, No. 20, 1986, Seiten 3827-3830 beschrieben. Weitere pH-abhängige Reaktionen mit Wasser sind beispielsweise die Hydrolyse von Anhydriden, Carbodiimiden, Oxazolidonen, Estern oder Isocyanaten.

Beispiele für solche latenten Systeme, die eine Veränderung des Milieus herbeiführen können, sind auf Onium-Salzen, insbesondere auf Sulfonium und lodonium, sowie auf Metallocen basierende Systeme.

Im Falle von Wasser hat das Gettermaterial seine geringste Aktivität gegenüber Wasser vorzugsweise im neutralen oder quasi-neutralen Milieu. Unter "neutralem Milieu" ist dabei ein Milieu zu verstehen, das in wässriger Lösung einem pH von 7 entspräche. Unter "quasineutralem Milieu" ist der Bereich zu verstehen, der in wässriger Lösung einem pH zwischen 6 und 8 entspräche, vorzugsweise einem pH von 6,5 bis 7,5. Im neutralen Milieu hat das Gettermaterial in diesem Fall seine geringste Reaktionsgeschwindigkeit für die Reaktion mit Wasser. Die Reaktionsgeschwindigkeit ist so gering, dass keine nennenswerte Reaktion mit Wasser(dampf) erfolgt. Wenn das Milieu hingegen sauer oder basisch wird, erhöht sich die Reaktionsgeschwindigkeit signifikant.

Auch andere dem Fachmann bekannte Katalysatoren sind für die Erfindung geeignet. Dies gilt insbesondere für Katalysatoren, die nano- oder mikroverkapselt sind. Diese Katalysatoren werden aktiviert, indem die Verkapselung aufgebrochen wird.

Die Menge an Katalysator, die in der erfindungsgemäßen Klebemasse enthalten ist, beträgt vorzugsweise weniger als 5 Gew.-%, bevorzugt weniger als 2 Gew.-% und insbesondere weniger als 1 Gew.-%. Es reichen also verhältnismäßig geringe Mengen aus, um die erfindungsgemäße Wirkung zu erreichen.

"Äußerer Stimulus" meint eine Einwirkung von außen auf den Katalysator, der diesen aktiviert.

Besonders geeignet als äußerer Stimulus sind UV-Strahlung, eine Temperaturveränderung, Mikrowellenstrahlung oder sichtbares Licht, wobei UV-Strahlung ganz besonders bevorzugt ist. Durch UV-Strahlung ist eine einfache Aktivierung möglich; auf der anderen Seite ist es unwahrscheinlich, dass die Klebemasse vor der gewünschten Applikation versehentlich einer UV-Strahlung ausgesetzt wird, so dass eine unbeabsichtigte Aktivierung vermieden werden kann.

Besonders bevorzugt umfasst die Klebemasse eine Klebstoffbasis aus mindestens einem Elastomer und mindestens einem Klebharz. Eine besonders geeignet Klebemasse umfasst damit Klebstoffbasis, Gettermaterial, optional ein Lösungsmittel sowie einen Katalysator für die Reaktion des Gettermaterials mit einem Permeaten, der mittels eines äußeren Stimulus aktivierbar ist.

Weiterhin ist die erfindungsgemäße Klebemasse vorzugsweise haftklebrig. Dies ermöglicht eine besonders gute Handhabbarkeit, da die Klebemasse auch vor der Vernetzung bereits an der zu verklebenden Stelle haftet.

Besonders gut geeignet ist die erfindungsgemäße Klebemasse, wenn sie des Weiteren mindestens ein Reaktivharz mit mindestens einer härtbaren Gruppe enthält. Solche Klebemassen können appliziert werden, sind aber zunächst noch verformbar. Erst nach erfolgter Reaktion der härtbaren Gruppe härtet die Klebemasse aus und entfaltet ihre vollständige Klebewirkung.

Als härtbare Gruppe sind dabei cyclischer Ether, Vinyl, Acrylat, Methacrylat, Hydroxyl, Amino und/oder Isocyanat besonders geeignet. Es können auch mehrere unterschiedliche härtbare Gruppen im Reaktivharz vorhanden sein.

Wenn die Klebemasse ein Reaktivharz enthält, sind solche Systeme besonders einfach in der Handhabung, bei denen der Stimulus für den Katalysator für die Reaktion des Gettermaterials mit Wasser gleichzeitig der Initiator für die Härtung des Reaktivharzes ist. Insbesondere UV-Strahlung ist hier als Stimulus besonders geeignet. Der Katalysator ist dann ein Photokatalysator.

Auf der anderen Seite sind auch solche Klebemassen gut geeignet, die kein Reaktivharz enthalten. Solche Klebemassen kommen ohne den zusätzlichen Schritt der Aushärtung aus, so dass in einem solchen System auf etwaige Anforderungen an die Aushärtung der reaktiven Gruppen keine Rücksicht genommen werden muss und einzig dafür Sorge zu tragen ist, dass das Gettermaterial in erforderlicher Weise aktiviert wird.

Insbesondere Haftklebemassen sind als Klebemassen ohne Reaktivharz besonders geeignet.

Vorzugsweise ist die Klebemasse eine Barriereklebemasse, deren Klebstoffbasis - im Falle des Vorhandenseins eines Reaktivharzes nach dessen Aushärtung - eine Wasserdampfpermeationsrate von weniger als 100 g/m²d, bevorzugt von weniger als 50 g/m²d, insbesondere weniger als 15 g/m²d aufweist.

Vorzugsweise weist die Klebemasse ein neutrales oder quasi-neutrales Milieu vor der Stimulation des Katalysators auf. Bevorzugt enthält also die Klebemasse keine sauren oder basischen Gruppen, insbesondere keine organischen Säuren, Acrylsäuren, Methacrylsäuren, Amine, Amide oder deren Polymere.

Besonders bevorzugt ist das Gettermaterial mindestens eine Verbindung, ausgewählt aus der Gruppe umfassend Alkoxysilane und Alkoxysiloxane. Diese Verbindungen gewährleisten ein neutrales Milieu. Dabei können die Alkoxysilane und Alkoxysiloxane bevorzugt als Monomere oder als Oligomere mit 2 bis 40 sich wiederholenden SiR₂-Gruppen sein. Die Verbindungen können kettenförmig oder ringförmig ausgebildet sein.

Unter "Silanen" werden Verbindungen der allgemeinen Formel Rₐ-Si-X₄₋ₐ oder deren partielle Kondensationsprodukte verstanden. In der Formel steht a für eine ganze Zahl von 0 bis 3 und bevorzugt für 0 oder 1. X steht für eine hydrolysierbare Gruppe, beispielsweise und bevorzugt für ein Halogen-Atom, insbesondere Chlor, eine Alkoxy-Gruppe wie beispielsweise eine Methoxy-, Ethoxy-, n-Propoxy-, iso-Propoxy-, n-Butoxy-, sec-Butoxy- oder tert-Butoxy-Gruppe oder für eine Acetoxy-Gruppe. Weitere, dem Fachmann bekannte Beispiele für hydrolysierbare Gruppen sind im Sinne der vorliegenden Erfindung ebenfalls einsetzbar. Sind mehrere Substituenten X vorhanden, so können diese gleich oder voneinander verschieden sein. R steht für einen gegebenenfalls substituierten Kohlenwasserstoffrest, beispielsweise für eine Methyl-, Ethyl-, n-Propyl-, iso-Propyl-, n-Butyl-, sec-Butyl-, tert-Butyl-Gruppe, eine Pentyl-Gruppe sowie deren verzweigte Isomere, eine Hexyl-Gruppen sowie die verzweigten Isomere, eine Heptyl-Gruppe sowie die verzweigten Isomere, eine Octyl-Gruppe sowie die verzweigten Isomere, eine Nonyl-Gruppe sowie die verzweigten Isomere, eine Decyl-Gruppe sowie die verzweigten Isomere, eine Undecyl-Gruppe sowie die verzweigten Isomere, eine Dodecyl-Gruppe sowie die verzweigten Isomere, eine Tetradecyl-Gruppe sowie die verzweigten Isomere, eine Hexadecyl-Gruppe sowie die verzweigten Isomere, eine Octadecyl-Gruppe sowie die verzweigten Isomere oder eine Eicosyl-Gruppe sowie die verzweigten Isomere. Die Kohlenwasserstoffreste können zudem ringförmige und/oder aromatische Bauteile enthalten. Repräsentative Strukturen dafür sind Cyclohexyl-, Phenyl- und Benzyl-Gruppen. Gegebenenfalls enthält/enthalten der/die Kohlenwasserstoffrest(e) R beispielsweise einen oder mehrere Heteroatom-haltige Substituenten wie Aminogruppen, Aminoalkylgruppen, Glycidyloxygruppen, (Meth)acryloxygruppen und dergleichen. Sind mehrere Substituenten R vorhanden, so können diese gleich oder voneinander verschieden sein.

Ein als Gettermaterial einsetzbares Silan ist bevorzugt ausgewählt aus der Gruppe umfassend N-(2-Aminoethyl)-3-aminopropyltrimethoxysilan, N-(2-Aminoethyl)-3-aminopropy-Itriethoxysilan, 3-Aminopropyltrimethoxysilan, 3-Aminopropyltriethoxysilan, 3-Aminopropy-Idiethoxymethylsilan, N-(2-Aminoethyl)-3-aminopropyldimethoxymethylsilan, (N-Butyl)-3-aminopropyltrimethoxysilan, 3-(N-Ethylamino)-2-methylpropyltrimethoxysilan, 4-Amino-3,3-dimethylbutyltrimethoxysilan, 4-Amino-3,3-dimethylbutyldimethoxymethylsilan, (N-Cyclohexyl)-aminomethyldimethoxymethylsilan, (N-Cyclohexyl)-aminomethyltrimethoxysilan, (N-Phenyl)-3-aminopropyltrimethoxysilan, (N-Phenyl)-aminomethyldimethoxymethylsilan, (N-Benzyl-2-aminoethyl)-3-aminopropyltrimethoxysilan, [2-(N-Benzyl-N-vinylamino)-ethyl]-3-aminopropyltrimethoxysilan Hydrogenchlorid, [2-(N-Benzyl-N-vinylamino)-ethyl]-3-aminopropyltrimethoxysilan, Bis-(3-propyltriethoxysilyl)-amin, Vinyltrimethoxysilan, Vinyltriethoxysilan, Vinyl-tri(2-methoxyethoxy)-silan, Vinyltriisopropoxysilan, Vinyldimethoxymethylsilan, Vinyltriacetoxysilan, 3-Triethoxysilylpropylbernsteinsäureanhydrid, 3-Glycidyloxypropyltrimethoxysilan, 3-Glycidyloxypropyltriethoxysilan, 2-(3,4-Epoxycyclohexyl)-ethyltriethoxysilan, 2-(3,4-Epoxycyclohexyl)-ethyltrimethoxysilan, 2-(3,4-Epoxycyclohexyl)-ethylmethyldimethoxysilan, 2-(3,4-Epoxycyclohexyl)-ethylmethyldiethoxysilan, Triethoxyoctylsilan, Trimethoxyoctylsilan, 3-Glycidyloxypropyldiethoxymethylsilan, 3-Methacryloyloxypropyltrimethoxysilan, 3-Methacryloyloxypropyltriethoxysilan, 3-Methacryloyloxypropyltriisopropoxysilan, 3-Methacryloyloxypropyldimethoxymethylsilan, 3-Methacryloyloxypropyldiethoxymethylsilan, 3-Chloropropyltrimethoxysilan, 3-Chloropropyltriethoxysilan, 3-Isocyanatopropyltrimethoxysilan, 3-Isocyanatopropyltriethoxysilan, Isocyanatomethyltrimethoxysilan, Isocyanatomethyldimethoxymethylsilan, Tris-[3-(trimethoxysilyl)-propyl]-isocyanurat, 3-Ureidopropyltrimethoxysilan, 3-Ureidopropyltriethoxysilan, 2-Hydroxy-4-(3-triethoxysilylpropoxy)-benzophenon, 4-(3'-Chlorodimethylsilylpropoxy)-benzophenon, 3-Mercaptopropyltrimethoxysilan, 3-Mercaptopropyldimethoxymethylsilan, Bis-(3-triethoxysilylpropyl)-disulfan, Bis-(3-triethoxysilylpropyl)-tetrasulfan, Bis-(triethoxysilylpropyl)-polysulfan und Octadecylaminodimethyltrimethoxysilylpropylammoniumchlorid. Es sind auch andere, nicht vernetzende, Alkoxysilane als Gettermaterial einsetzbar.

Als Siloxane im Sinne der Erfindung werden Verbindungen verstanden, die mindestens zwei über ein Sauerstoffatom verbundene SiR₂-Gruppen aufweisen. Bei den erfindungsgemäß besonders geeigneten Alkoxysiloxanen ist mindestens ein Rest R eine Alkoxygruppe. Beispiele für erfindungsgemäß besonders geeignete Siloxane sind Oligomere oder Polymere der im vorstehenden Absatz genannten Silane.

Vorzugsweise weist der Getter mindestens eine härtbare Gruppe auf. Als härtbare Gruppe besonders geeignet sind dabei cyclischer Ether, Vinyl, Acrylat, Methacrylat, Hydroxyl, Amino oder Isocyanat.

Im Falle von Alkoxysiloxanen als Getter weist das Alkoxysiloxan vorzugsweise pro Si-Atom eine Alkoxygruppe und eine härtbare Gruppe auf. Dabei kann die Alkoxygruppe gleich oder verschieden zu benachbarten Si-Alkoxygruppen sein. Ebenso kann die härtbare Gruppe benachbarter Wiederholungseinheiten gleich oder verschieden sein.

Das Gettermaterial weist mindestens eine Ethoxysilangruppe und mindestens eine härtbare Gruppe auf, wobei die härtbare Gruppe eine cyclische Ethergruppe ist. Als cyclische Ethergruppe sind eine Epoxid- oder eine Oxirangruppe besonders geeignet, wobei die Silane 2-(3,4-Epoxycyclohexyl)ethyltrimethoxysilan und insbesondere 2-(3,4-Epoxycyclohexyl)ethyltriethoxysilan und 2-(3,4-Epoxycyclohexyl)ethylmethyl-diethoxysilan besonders bevorzugt sind.

Besonders gute Eigenschaften weisen Klebemassen auf, bei denen die Menge an Gettermaterial mindestens 2 Gew.-%, bevorzugt mindestens 3 Gew.-% und insbesondere mindestens 5 Gew.-% beträgt. Dabei sind ganz besonders solche Klebemassen vorteilhaft, bei denen die Menge an Gettermaterial 3 bis 15 Gew.-%, vorzugsweise 4 bis 10 Gew.-% und insbesondere 4,5 bis 7 Gew.-% beträgt.

Der Anteil des Reaktivharzes in der Klebemasse beträgt von 15 bis 80 Gew.-%, insbesondere von 20 bis 70 Gew.-% und besonders bevorzugt von 25 bis 65 Gew.-%. Um eine gute Handhabbarkeit und elastische Klebmasse nach Aushärtung zu erzielen, ist ein bevorzugter Reaktivharzanteil 15 bis 35 Gew.-%, insbesondere 20 bis 30 Gew.-%. Für stärker vernetzte Verklebungen sind Reaktivharzanteile von 65 bis 80 Gew.-% bevorzugt. Besonders ausgewogen in Bezug auf Elastizität und Vernetzungsgrad sind Reaktivharzanteile von 35 bis 65 Gew.-%.

In einer bevorzugten Ausführung enthält das Reaktivharz Epoxidgruppen, insbesondere aliphatische und ganz besonders bevorzugt cycloaliphatische Epoxidgruppen. Sehr gut geeignet sind Reaktivharze, die als härtbare Gruppe Glycidyl- und/oder Epoxycyclohexylgruppen enthalten.

Ganz besonders geeignet sind Klebemassen, in denen Reaktivharz und Alkoxysilan beziehungsweise Alkoxysiloxan gleichartige, insbesondere dieselben härtbaren Gruppen aufweisen. In diesem Fall können Reaktivharz und Alkoxysilan beziehungsweise -siloxan auf besonders gute Weise miteinander polymerisieren und vernetzen. Unter "gleichartigen funktionellen härtbaren Gruppen" sind dabei solche zu verstehen, die einander chemisch sehr ähnlich sind wie zum Beispiel cyclische Ether mit verschiedener Ringgröße oder Epoxyether, deren cycloaliphatische Gerüste eine unterschiedliche Ringgröße aufweisen.

In einer bevorzugten Ausführung wird die Klebemasse kationisch, thermisch oder strahleninduziert ausgehärtet. Weiterhin ist es bevorzugt, dass die Klebemasse zumindest eine Sorte eines Photoinitiators für die kationische Härtung der vernetzbaren Komponente enthält.

In einer besonders bevorzugten Ausführungsform enthält die Klebemasse ein Reaktivharz und die Schritte des Aushärtens und des Aktivierens des Getters erfolgen gleichzeitig und Aushärten und Aktivieren werden auf dieselbe Weise induziert. So kann zum Beispiel die Vernetzungsreaktion des Reaktivharzes UV-induziert eingeleitet werden. Durch UV-Strahlung kann auch eine Änderung des Milieus von neutral zu zum Beispiel sauer bewirkt werden, was wiederum die Aktivierung des Getters zur Folge hat. Die parallele Aushärtung und Aktivierung ist besonders geeignet, weil nur ein Schritt erforderlich ist, nachdem die Klebemasse oder das Klebeband appliziert wurde. Ebenso wird nur eine Vorrichtung wie zum Beispiel eine UV-Strahlungsquelle benötigt. Ebenso können Aushärtung und Getteraktivierung thermisch induziert werden.

Als Haftklebemassen werden Klebemassen bezeichnet, die bereits unter relativ schwachem Andruck eine dauerhafte Verbindung mit dem Haftgrund erlauben und nach Gebrauch im Wesentlichen rückstandsfrei vom Haftgrund wieder abgelöst werden können. Haftklebemassen wirken bei Raumtemperatur permanent haftklebrig, weisen also eine hinreichend geringe Viskosität und eine hohe Anfassklebrigkeit auf, so dass sie die Oberfläche des jeweiligen Klebegrunds bereits bei geringem Andruck benetzen. Die Verklebbarkeit entsprechender Klebemassen beruht auf ihren adhäsiven Eigenschaften und die Wiederablösbarkeit auf ihren kohäsiven Eigenschaften. Als Basis für Haftklebemassen kommen verschiedene Materialien in Frage.

Das Polymer kann ein Polymer sein, aber auch eine Mischung von zwei oder mehr verschiedenen Polymeren sein. Dabei kann das mindestens eine Polymer insbesondere ein Elastomer oder ein Thermoplast sein.

Als Elastomere können prinzipiell alle im Bereich der Haftklebemassen üblichen Elastomere verwendet werden, wie sie zum Beispiel in dem "Handbook of Pressure Sensitive Adhesive Technology" von Donatas Satas (Satas & Associates, Warwick 1999), beschrieben sind.

Bevorzugt im Sinne der Anmeldung sind die verwendeten Elastomere chemisch aus zumindest einem olefinischen Monomer oder aus Polyurethan aufgebaut und sind zum Beispiel Elastomere auf der Basis von Polyurethanen, Naturkautschuken, Synthesekautschuken wie Butyl-, (Iso)Butyl-, Nitril- oder Butadienkautschuke, Styrolblockcopolymeren mit einem Elastomerblock aus ungesättigten oder teilweise oder vollständig hydrierten Polydienblöcken (Polybutadien, Polyisopren, Poly(iso)butylen, Copolymeren aus diesen sowie weitere, dem Fachmann geläufige Elastomerblöcke), Polyolefinen, Fluorpolymeren und/oder Silikonen.

Vorzugsweise ist das mindestens eine Elastomer aufgebaut aus zumindest einem olefinischen Monomer und/oder aus zumindest einem Polyurethan. Besonders bevorzugt ist das Elastomer mindestens ein Vinylaromatenblockcopolymer.

Kommt Kautschuk oder Synthesekautschuk oder daraus erzeugte Verschnitte als Basismaterial für die Haftklebemasse zum Einsatz, dann kann der Naturkautschuk grundsätzlich aus allen erhältlichen Qualitäten wie zum Beispiel Crepe-, RSS-, ADS-, TSR- oder CV-Typen, je nach benötigtem Reinheits- und Viskositätsniveau, und der Synthesekautschuk oder die Synthesekautschuke aus der Gruppe der statistisch copolymerisierten Styrol-Butadien-Kautschuke (SBR), der Butadien-Kautschuke (BR), der synthetischen Polyisoprene (IR), der Butyl-Kautschuke (IIR), der halogenierten Butyl-Kautschuke (XIIR), der Acrylat-Kautschuke (ACM), der Ethylenvinylacetat-Copolymere (EVA) oder der Polyurethane und/oder deren Verschnitten gewählt werden.

Als das mindestens eine Polymer kann auch jegliche dem Fachmann bekannte Art von Thermoplasten zum Einsatz kommen, wie sie zum Beispiel in den Lehrbüchern "Chemie und Physik der synthetischen Polymere" von J.M.G. Cowie (Vieweg, Braunschweig) und "Makromolekulare Chemie" von B. Tieke (VCH Weinheim, 1997) genannt sind. Dies sind zum Beispiel Poly(ethylen), Poly (propylen), Poly (vinylchlorid), Poly (styrol), Poly (oxymethylene), Poly (ethylenoxid), Poly (ethylenterephthalat), Poly (carbonate), Poly (phenylenoxide), Poly (urethane), Poly(harnstoffe), Phenoxy-Harze, Acrylnitril-Butadien-Styrol (ABS), Poly(amide) (PA), Poly (lactat) (PLA), Poly (etheretherketon) (PEEK), Poly (sulfon) (PSU), Poly (ethersulfon) (PES). Poly (acrylate), Poly (methacrylate) und Poly (methylmethacrylate) (PMMA) sind zwar als Polymer ebenfalls möglich, jedoch nicht bevorzugt im Sinne der vorliegenden Erfindung.

Als latente Katalysatoren für die Katalyse der Hydrolyse von Alkoxysilanen sind insbesondere auf Sulfonium, lodonium und Metallocen basierende Systeme einsetzbar. Als Beispiele für Sulfonium basierende Kationen sei auf die Ausführungen in US 6,908,722 B1 (insbesondere Spalten 10 bis 21) verwiesen.

Als Beispiele für Anionen, die als Gegenionen für die oben genannten Kationen dienen, seien Tetrafluoroborat, Tetraphenylborat, Hexafluorophosphat, Perchlorat, Tetrachloroferrat, Hexafluoroarsenat, Hexafluoroantimonat, Pentafluorohydroxyantimonat, Hexachloroantimonat, Tetrakispentafluorophenylborat, Tetrakis-(pentafluoromethylphenyl)-borat, Bi-(trifluoromethylsulfonyl)-amide und Tris-(trifluoromethylsulfonyl)-methide genannt. Ferner sind insbesondere für lodonium-basierende Initiatoren auch Chlorid, Bromid oder Iodid als Anionen denkbar, wobei aber Initiatoren, die im Wesentlichen frei von Chlor und Brom sind, bevorzugt sind.

Konkreter zählen zu den einsetzbaren Systemen
- Sulfonium-Salze (siehe zum Beispiel US 4,231,951 A, US 4,256,828 A, US 4,058,401 A, US 4,138,255 A und US 2010/063221 A1) wie Triphenylsulfoniumhexafluoroarsenat, Triphenylsulfoniumhexafluoroborat, Triphenylsulfoniumtetrafluoroborat, Triphenylsulfoniumtetrakis-(pentafluorobenzyl)-borat, Methyldiphenylsulfoniumtetrafluoroborat, Methyldiphenylsulfoniumtetrakis-(pentafluorobenzyl)-borat, Dimethylphenylsulfoniumhexafluorophosphat, Triphenylsulfoniumhexafluorophosphat, Triphenylsulfoniumhexafluoroantimonat, Diphenylnaphthylsulfoniumhexafluoroarsenat, Tritolylsulfoniumhexafluorophosphat, Anisyldiphenylsulfoniumhexafluoroantimonat, 4-Butoxyphenyldiphenylsulfoniumtetrafluoroborat, 4-Chlorophenyldiphenylsulfoniumhexafluoroantimonat, Tris-(4-phenoxyphenyl)-sulfoniumhexafluorophosphat, Di-(4-ethoxyphenyl)-methylsulfoniumhexafluoroarsenat, 4-Acetylphenyldiphenylsulfoniumtetrafluoroborat, 4-Acetylphenyldiphenylsulfoniumtetrakis-(pentafluorobenzyl)-borat, Tris-(4-thiomethoxyphenyl)-sulfoniumhexafluorophosphat, Di-(methoxysulfonylphenyl)-methylsulfoniumhexafluoroantimonat, Di-(methoxynaphthyl)-methylsulfoniumtetrafluoroborat, Di-(methoxynaphthyl)-methylsulfoniumetrakis-(pentafluorobenzyl)-borat, Di-(carbomethoxyphenyl)-methylsulfoniumhexafluorophosphat, (4-Octyloxyphenyl)-diphenylsulfoniumtetrakis-(3,5-bis-trifluoromethylphenyl)-borat, Tris-[4-(4-acetylphenyl)-thiophenyl]-sulfoniumtetrakis-(pentafluorophenyl)-borat, Tris-(dodecylphenyl)-sulfoniumtetrakis-(3,5-bis-trifluoromethylphenyl)-borat, 4-Acetamidphenyldiphenylsulfoniumtetrafluoroborat, 4-Acetamidphenyldiphenylsulfoniumtetrakis-(pentafluorobenzyl)-borat, Dimethylnaphthylsulfoniumhexafluorophosphat, Trifluoromethyldiphenylsulfoniumtetrafluoroborat, Trifluoromethyldiphenylsulfoniumtetrakis-(pentafluorobenzyl)-borat, Phenylmethylbenzylsulfoniumhexafluorophosphat, 5-Methylthianthreniumhexafluorophosphat, 10-Phenyl-9,9-dimethylthioxantheniumhexafluorophosphat, 10-Phenyl-9-oxothioxantheniumtetrafluoroborat, 10-Phenyl-9-oxothioxantheniumtetrakis-(pentafluorobenzyl)-borat, 5-Methyl-10-oxothianthreniumtetrafluoroborat, 5-Methyl-10-oxothianthreniumtetrakis-(pentafluorobenzyl)-borat und 5-Methyl-10,10-dioxothianthreniumhexafluorophosphat,
- lodonium-Salze (siehe zum Beispiel US 3,729,313 A, US 3,741,769 A,
   US 4,250,053 A, US 4,394,403 A und US 2010/063221 A1) wie Diphenyliodoniumtetrafluoroborat,
   Di-(4-methylphenyl)-iodoniumtetrafluoroborat,
   Phenyl-4-methylphenyliodoniumtetrafluoroborat,
   Di-(4-chlorphenyl)-iodoniumhexafluorophosphat, Dinaphthyliodoniumtetrafluoroborat,
   Di-(4-trifluormethylphenyl)-iodoniumtetrafluoroborat, Diphenyliodoniumhexafluorophosphat,
   Di-(4-methylphenyl)-iodoniumhexafluorophosphat, Diphenyliodoniumhexafluoroarsenat,
   Di-(4-phenoxyphenyl)-iodoniumtetrafluoroborat,
   Phenyl-2-thienyliodoniumhexafluorophosphat,
   3,5-Dimethylpyrazolyl-4-phenyliodoniumhexafluorophosphat, Diphenyliodoniumhexafluoroantimonat,
   2,2'-Diphenyliodoniumtetrafluoroborat,
   Di-(2,4-dichlorphenyl)-iodoniumhexafluorophosphat,
   Di-(4-bromphenyl)-iodoniumhexafluorophosphat,
   Di-(4-methoxyphenyl)-iodoniumhexafluorophosphat,
   Di-(3-carboxyphenyl)-iodoniumhexafluorophosphat,
   Di-(3-methoxycarbonylphenyl)-iodoniumhexafluorophosphat,
   Di-(3-methoxysulfonylphenyl)-iodoniumhexafluorophosphat,
   Di-(4-acetamidophenyl)-iodoniumhexafluorophosphat,
   Di-(2-benzothienyl)-iodoniumhexafluorophosphat,
   Diaryliodoniumtristrifluormethylsulfonylmethid wie
   Diphenyliodoniumhexafluoroantimonat,
   Diaryliodoniumtetrakis-(pentafluorophenyl)-borat wie
   Diphenyliodoniumtetrakis-(pentafluorophenyl)-borat,,
   (4-n-Desiloxyphenyl)-phenyliodoniumhexafluoroantimonat,
   [4-(2-Hydroxy-n-tetradesiloxy)-phenyl]-phenyliodoniumhexafluoroantimonat,
   [4-(2-Hydroxy-n-tetradesiloxy)-phenyl]-phenyliodoniumtrifluorosulfonat,
   [4-(2-Hydroxy-n-tetradesiloxy)-phenyl]-phenyliodoniumhexafluorophosphat,
   [4-(2-Hydroxy-n-tetradesiloxy)-phenyl]-phenyliodoniumtetrakis-(pentafluorophenyl)-borat,
   Bis-(4-tert-butylphenyl)-iodoniumhexafluoroantimonat,
   Bis-(4-tert-butylphenyl)-iodoniumhexafluorophosphat,
   Bis-(4-tert-butylphenyl)-iodoniumtrifluorosulfonat,
   Bis-(4-tert-butylphenyl)-iodoniumtetrafluoroborat,
   Bis-(dodecylphenyl)-iodoniumhexafluoroantimonat,
   Bis-(dodecylphenyl)-iodoniumtetrafluoroborat,
   Bis-(dodecylphenyl)-iodoniumhexafluorophosphat,
   Bis-(dodecylphenyl)-iodoniumtrifluoromethylsulfonat,
   Di-(dodecylphenyl)-iodoniumhexafluoroantimonat,
   Di-(dodecylphenyl)-iodoniumtriflat,
   Diphenyliodoniumbisulfat,
   4,4'-Dichlorodiphenyliodoniumbisulfat, 4,4'-Dibromodiphenyliodoniumbisulfat,
   3,3'-Dinitrodiphenyliodoniumbisulfat, 4,4'-Dimethyldiphenyliodoniumbisulfat,
   4,4'-Bis-succinimidodiphenyliodoniumbisulfat, 3-Nitrodiphenyliodoniumbisulfat, 4,4'-Dimethoxydiphenyliodoniumbisulfat,
   Bis-(dodecylphenyl)-iodoniumtetrakis-(pentafluorophenyl)-borat,
   (4-Octyloxyphenyl)-phenyliodoniumtetrakis-(3,5-bis-trifluoromethylphenyl)-borat und (Tolylcumyl)-iodoniumtetrakis-(pentafluorophenyl)-borat,
   und
- Ferrocenium-Salze (siehe zum Beispiel EP 542 716 B1) wie η5-(2,4-cyclopentadien-1-yl)-[(1,2,3,4,5,6,9)-(1-methylethyl)-benzol]-eisen.

Darüber hinaus sind photolatente Basen in dem Aufsatz "Photolatent bases: new catalysts for UV-curing of coatings" von J. Studer et al., der auf der Radtech e5: UV & EB Technology Conference 2006 (RadTech International, NA, 23.-26. April 2006, Lakeside Center at McCormick Place - Chicago, IL) vorgestellt wurde, beschrieben. Darin genannte Beispiele für photolatente Basen sind Ammoniumsalze von Phenylglyoxylaten, Benzhydrylammoniumsalze, N-Benzophenonmethyl-tri-N-alkylammoniumsalze, Aminimidderivate, α-Ammonium acetophenon Salze oder N-Methlynifedipine. Weitere Beispiele für photolatente Basen finden sich in "Coatings & Inks - Photoinitiators Part 3: What's New or May Be Coming" (Gordon Bradley, 24.01.2007) und in den darin angeführten US-Patenten US 6,489,374, US 6,087,070, US 20040242867 und US 20030212164, so zum Beispiel 4-(Ortho-nitrophenyl)dihydropyridin, quarternäre Organobor-Photoinitiatoren, α-Aminoacetophenone sowie Tetra- oder Tri-arylalkylborate von α-Ammoniumalkenen, Iminiumalkenen oder Amidiniumalkenen sowie unter UV-Licht DBN (1,5-Diazabicyclo[4.3.0]non-5-en) freisetzende Verbindungen.

Andere aktivierbare Katalysatoren sind durch dem Fachmann bekannte Methoden der nano- beziehungsweise Mikroverkapselung bekannt und ausführlich in "Encapsulation Nanotechnologies" edited by Vikas Mittal, Wiley beschrieben. Typische Freisetzungsmechanismen werden dort in Kapitel 10.8.2 beschrieben.

Geeignet als optional enthaltene Klebharze sind Klebharze, wie sie dem Fachmann zum Beispiel aus dem Satas bekannt sind.

Besonders vorteilhaft enthält die Haftklebemasse zumindest eine Sorte eines vorzugsweise zumindest teilhydrierten Klebharzes, vorteilhaft solche, die mit der Elastomerkomponente beziehungsweise, sofern ein aus Hart- und Weichblöcken aufgebautes Copolymer eingesetzt wird, hauptsächlich mit dem Weichblock verträglich sind (Weichharze).

Es ist vorteilhaft, wenn entsprechendes Klebharz eine Erweichungstemperatur gemessen mittels Ring&Ball-Methode von größer 25 °C aufweist. Es ist darüber hinaus vorteilhaft, wenn ergänzend zumindest eine Sorte Klebharz mit einer Erweichungstemperatur von kleiner 20 °C eingesetzt wird. Hierüber kann, falls erforderlich, zum einen das klebtechnische Verhalten, zum anderen aber auch das Auffließverhalten auf dem Verklebungsuntergrund feineingestellt werden.

Für eher unpolare Elastomere können als Harze in der Haftklebemasse vorteilhaft partiell oder vollständig hydrierte Harze auf Basis von Kolophonium und Kolophoniumderivaten, hydrierte Polymerisate des Dicyclopentadiens, partiell, selektiv oder vollständig hydrierte Kohlenwasserstoffharze auf Basis von C₅-, C₅/C₉- oder C₉-Monomerströmen, Polyterpenharze auf Basis von α-Pinen und/oder β-Pinen und/oder δ-Limonen und/oder Δ³-Caren, hydrierte Polymerisate von bevorzugt reinen C₈- und C₉-Aromaten eingesetzt werden. Vorgenannte Klebharze können sowohl allein als auch im Gemisch eingesetzt werden.

Dabei können sowohl bei Raumtemperatur feste als auch flüssige Harze zum Einsatz kommen. Um eine hohe Alterungs- und UV-Stabilität zu gewährleisten, sind hydrierte Harze mit einem Hydrierungsgrad von mindestens 90 %, vorzugsweise von mindestens 95 % bevorzugt.

Als optional enthaltene Reaktivharze, die auch als vernetzbare Komponenten bezeichnet werden, können im Prinzip alle, dem Fachmann im Bereich der Haftklebemassen oder Reaktivklebstoffe bekannten, in einer Aufbaureaktion vernetzenden Makromoleküle bildenden reaktiven Konstituenten verwendet werden, wie sie zum Beispiel in Gerd Habenicht: Kleben -Grundlagen, Technologien, Anwendungen, 6. Auflage, Springer, 2009, beschrieben sind. Dies sind beispielhaft Konstituenten, die Epoxide, Polyester, Polyether, Polyurethane, Phenolharz, Kresol oder Novolak basierte Polymere, Polysulfide oder Acrylpolymere (Acryl, Methacryl) bilden.

Der Aufbau und die chemische Beschaffenheit der vernetzbaren Komponenten sind nicht kritisch, solange sie mit der Elastomerphase zumindest teilweise mischbar sind und die Aufbaureaktion unter Bedingungen, insbesondere hinsichtlich der angewendeten Temperaturen, Art der verwendeten Katalysatoren und dergleichen, durchgeführt werden kann, die zu keiner wesentlichen Beeinträchtigung und/oder Zersetzung der Elastomerphase führen.

Das Reaktivharz besteht bevorzugt aus einem cyclischen Ether und eignet sich für die strahlenchemische und gegebenenfalls thermische Vernetzung mit einer Erweichungstemperatur von kleiner 40 °C, bevorzugt von kleiner 20 °C.

Bei den Reaktivharzen auf Basis cyclischer Ether handelt es sich insbesondere um Epoxide, also Verbindungen, die zumindest eine Oxiran-Gruppe tragen, oder Oxetane. Sie können aromatischer oder insbesondere aliphatischer oder cycloaliphatischer Natur sein.

Einsetzbare Reaktivharze können monofunktionell, difunktionell, trifunktionell, tetrafunktionell oder höher funktionell bis zu polyfunktionell gestaltet sein, wobei sich die Funktionalität auf die cyclische Ethergruppe bezieht.

Beispiele, ohne sich einschränken zu wollen, sind 3,4-Epoxycyclohexylmethyl-3',4'-epoxycyclohexancarboxylat (EEC) und Derivate, Dicyclopendadiendioxid und Derivate, 3-Ethyl-3-oxetanmethanol und Derivate, Tetrahydrophthalsäurediglycidylester und Derivate, Hexahydrophthalsäurediglycidylester und Derivate, 1,2-Ethandiglycidylether und Derivate, 1,3-Propandiglycidylether und Derivate, 1,4-Butandioldiglycidylether und Derivate, höhere 1,n-Alkandiglycidylether und Derivate, Bis-[(3,4-epoxycyclohexyl)methyl]-adipat und Derivate, Vinylcyclohexyldioxid und Derivate, 1,4-Cyclohexandimethanol-bis-(3,4-epoxycyclohexancarboxylat) und Derivate, 4,5-Epoxytetrahydrophthalsäurediglycidylester und Derivate, Bis-[1-ethyl(3-oxetanyl)methyl)ether und Derivate, Pentaerythritoltetraglycidylether und Derivate, Bisphenol-A-Digylcidylether (DGEBA), hydriertes Bisphenol-A-Diglycidylether, Bisphenol-F-Diglycidylether, hydriertes Bisphenol-F-Diglycidylether, Epoxyphenol-Novolaks, hydrierte Epoxyphenol-Novolaks, Epoxycresol-Novolaks, hydrierte Epoxycresol-Novolaks, 2-(7-Oxabicyclo;Spiro[1,3-dioxane-5,3'-[7]oxabicyclo[4.1.0]-heptane], 1,4-Bis((2,3-epoxypropoxy)methyl)cyclohexane.

Zur kationischen Härtung eignen sich besonders Reaktivharze auf Cyclohexylepoxid-Basis wie beispielsweise 3,4-Epoxycyclohexylmethyl-3',4'-epoxycyclohexancarboxylat (EEC) und Derivate sowie Bis-[(3,4-epoxycyclohexyl)methyl]-adipat und Derivate.

Reaktivharze können in ihrer monomeren oder auch dimeren, trimeren, usw. bis hin zu ihrer oligomeren Form eingesetzt werden.

Gemische von Reaktivharzen untereinander aber auch mit anderen coreaktiven Verbindungen wie Alkoholen (monofunktionell oder mehrfach funktionell) oder Vinylethern (monofunktionell oder mehrfach funktionell) sind ebenfalls möglich.

Besonders bevorzugt ist die erfindungsgemäße Klebemasse haftklebrig. Dies ermöglicht eine besonders gute Handhabbarkeit, da die Klebemasse auch vor der Vernetzung bereits an der zu verklebenden Stelle haftet.

Als Haftklebemassen werden Klebemassen bezeichnet, die bereits unter relativ schwachem Andruck eine dauerhafte Verbindung mit dem Haftgrund erlauben und nach Gebrauch im Wesentlichen rückstandsfrei vom Haftgrund wieder abgelöst werden können. Haftklebemassen wirken bei Raumtemperatur permanent haftklebrig, weisen also eine hinreichend geringe Viskosität und eine hohe Anfassklebrigkeit auf, so dass sie die Oberfläche des jeweiligen Klebegrunds bereits bei geringem Andruck benetzen. Die Verklebbarkeit entsprechender Klebemassen beruht auf ihren adhäsiven Eigenschaften und die Wiederablösbarkeit auf ihren kohäsiven Eigenschaften. Als Basis für Haftklebemassen kommen verschiedene Materialien in Frage.

Die vorliegende Erfindung betrifft darüber hinaus ein Klebeband, das auf einer Seite oder auf beiden Seiten mit der erfindungsgemäßen Klebemasse beschichtet ist. Dabei kann es sich bei dem Klebeband auch um ein Transferklebeband handeln. Ein Klebeband ermöglicht eine besonders einfache und präzise Verklebung und ist daher besonders geeignet. Schließlich betrifft die vorliegende Erfindung die Verwendung der erfindungsgemäßen Klebemasse beziehungsweise des erfindungsgemäßen Klebebandes als Dichtmasse, insbesondere zur Verkapselung von Aufbauten in der organischen Elektronik. Wie oben ausgeführt, ist es in der organischen Elektronik von eminenter Bedeutung, die Komponenten vor Wasser(dampf) geschützt werden müssen. Aufgrund ihrer sehr guten Barriereeigenschaften sind die erfindungsgemäßen Klebemassen beziehungsweise Klebebänder in der Lage, einen entsprechenden Schutz zu gewähren. Aufgrund der hohen Transparenz und der geringen Schädigung der zu verkapselnden Elektronik sind die erfindungsgemäße Klebemasse und das erfindungsgemäße Klebeband neben einer Randverkapselung insbesondere auch für eine vollflächige Verkapselung von organischer Elektronik geeignet.

Schließlich betriff die vorliegende Erfindung ein Verfahren zum Applizieren einer Klebemasse oder eines Klebebandes mit einer Klebemasse einer erfindungsgemäßen Klebemasse oder eines erfindungsgemäßen Klebebandes, das die Schritte
- Aufbringen der Klebemasse oder des Klebebandes auf den zu verklebenden Gegenstand und
- Aktivieren des Gettermaterials mittels eines äußeren Stimulus umfasst.

Mit diesem Verfahren ist es möglich, dass die Barrierewirkung eine Klebemasse oder ein Klebeband erst dann entfaltet wird, wenn sie auch benötigt wird, das heißt, wenn sie einen zu schützenden Gegenstand verkapselt oder bedeckt. Erst ab diesem Zeitpunkt ist der Getter als Wasserfänger aktiv. Da die Getterfunktion zuvor nicht aktiviert ist, wird der Getter nicht während des vorgeschalteten Lagerns oder Transports verbraucht.

Der allgemeine Ausdruck "Klebeband" umfasst ein Trägermaterial, welches ein- oder beidseitig mit einer (Haft)klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-)elektronischen Anordnung), Mehrschichtanordnungen und dergleichen. Dabei sind für verschiedene Anwendungen unterschiedlichste Träger wie zum Beispiel Folien, Gewebe, Vliese und Papiere mit den Klebmassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-) elektronischen Anordnungen verwendet werden.

Es sind aber auch Klebebänder möglich, bei denen nicht mit zwei Linern sondern mit einem einzigen doppelseitig trennend ausgerüstet Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien:
Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (Pl).

Polyesterfolien weisen den Vorteil auf, dass sie für Temperaturstabilität sorgen und eine erhöhte mechanische Stabilität einbringen. Ganz besonders bevorzugt besteht daher eine Trägerschicht in einem erfindungsgemäßen Liner aus einer Polyesterfolie, beispielsweise aus biaxial verstrecktem Polyethylenterephthalat.

In einer bevorzugten Ausführungsform enthält das Trägermaterial auch eine Barrierefunktion gegen ein oder mehrere spezifische(s) Permeat(e), insbesondere gegen Wasserdampf und Sauerstoff. Eine derartige Barrierefunktion kann aus organischen oder anorganischen Materialien bestehen. Trägermaterialien mit Barrierefunktion sind in EP 2 078 608 A1 ausführlich dargestellt.

Besonders bevorzugt enthält das Trägermaterial mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle, wie Aluminium, Silber, Gold, Nickel oder insbesondere Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Bei doppelseitig (selbst)klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.

In einer Variante ist in dem doppelseitig (selbst)klebenden Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Die Dicke der Haftklebemasse, die entweder als Transferklebeband oder auf einem flächigen Gebilde beschichtet vorliegt, beträgt bevorzugt zwischen 1 µm und 2000 µm, weiter bevorzugt zwischen 5 µm und 500 µm und besonders bevorzugt zwischen etwa 12 µm und 250 µm.

Schichtdicken zwischen 50 µm und 150 µm werden dann eingesetzt, wenn eine verbesserte Haftung auf dem Substrat und/oder eine dämpfende Wirkung erreicht werden soll.

Schichtdicken zwischen 1 µm und 50 µm reduzieren den Materialeinsatz. Jedoch kommt es zu einer Verringerung der Haftung auf dem Substrat.

Für doppelseitige Klebebänder gilt für die Klebemasse(n) ebenfalls, dass die Dicke der einzelnen Haftklebemasseschicht(en) bevorzugt zwischen 1 µm und 2000 µm, weiter bevorzugt zwischen 5 µm und 500 µm und besonders bevorzugt zwischen etwa 12 µm und 250 µm liegt. Kommt in doppelseitigen Klebebändern neben der einen erfindungsgemäßen Klebemasse eine weitere zum Einsatz, dann kann es auch vorteilhaft sein, wenn ihre Dicke oberhalb 150 µm liegt.

Klebebänder, die ein- oder beidseitig mit Klebstoffen beschichtet sind, werden am Ende des Herstellungsprozesses zumeist zu einer Rolle in Form einer archimedischen Spirale aufgewickelt. Um bei doppelseitig klebenden Klebebändern zu verhindern, dass die Klebemassen miteinander in Kontakt kommen, oder um bei einseitig klebenden Klebebändern eine Verklebung der Klebemasse auf dem Träger zu verhindern, werden die Klebebänder vor dem Wickeln mit einem Abdeckmaterial (auch als Trennmaterial bezeichnet) eingedeckt, das zusammen mit dem Klebeband aufgewickelt wird. Dem Fachmann sind derartige Abdeckmaterialien unter den Namen Liner oder Releaseliner bekannt. Neben der Abdeckung von ein- oder doppelseitig klebenden Klebebändern werden Liner auch zur Eindeckung von reinen Klebemassen (Transferklebeband) und Klebebandabschnitten (zum Beispiel Etiketten) eingesetzt.

Ein weiterer Hauptanspruch betrifft ein Verfahren zum Schutz einer auf einem Substrat angeordneten organischen elektrischen Anordnung, wobei eine Abdeckung derart auf die elektronische Anordnung aufgebracht wird, dass die elektronische Anordnung zumindest teilweise durch die Abdeckung überdeckt wird, wobei weiterhin die Abdeckung zumindest teilflächig auf dem Substrat und/oder auf der elektronischen Anordnung verklebt wird, wobei die Verklebung mittels zumindest einer Schicht einer Klebemasse bewirkt wird. Die Klebemassenschicht liegt dabei insbesondere als Schicht eines Klebebandes vor.

Das erfindungsgemäße Verfahren kann vorteilhaft derart geführt werden, dass zunächst die (Haft-)Klebstoffschicht, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird. In einer weiteren vorteilhaften Vorgehensweise werden die (Haft-)Klebstoffschicht, gegebenenfalls als Bestandteil eines weitere Schichten umfassenden doppelseitig klebenden Klebebandes, und die Abdeckung gemeinsam auf das Substrat und/oder die elektronische Anordnung aufgebracht.

Beim erfindungsgemäßen Verfahren kann das Transferklebeband somit zunächst mit dem Substrat beziehungsweise der elektronischen Anordnung verbunden werden oder zuerst mit der Abdeckung. Bevorzugt ist jedoch, zunächst das Transferklebeband mit der Abdeckung zu verbinden, da somit eine Baugruppe der elektronischen Funktionseinheit unabhängig von der elektronischen Anordnung vorgefertigt und als Ganzes zulaminiert werden kann.

Vorteilhaft kann das erfindungsgemäße Verfahren derart geführt werden, dass die Abdeckung und/oder die (Haft-)Klebstoffschicht, insbesondere als Transferklebeband, die elektronische Anordnung vollständig überdecken, da dann die lichtstreuende Wirkung die gesamte Fläche der Anordnung betrifft.

Durch die vollflächige Lamination des Transferklebebands über die elektronische Anordnung wird zudem die Einwirkung möglicherweise im Gasraum einer lediglich randverkapselten Anordnung eingeschlossener schädlicher Permeate ausgeschlossen, da es keinen Gasraum gibt.

Das erfindungsgemäße Verfahren wird bevorzugt derart geführt, dass auch ein Bereich des Substrats um die elektronische Anordnung herum durch die Abdeckung ganz oder teilweise überdeckt wird, wobei das Klebeband zur Verklebung die elektronische Anordnung dabei vollflächig bedecken kann und bevorzugt ebenfalls einen Bereich des Substrats um die elektronische Anordnung herum bedeckt, bevorzugt denselben Bereich wie die Abdeckung - oder teilflächig aufgebracht sein kann, etwa rahmenförmig um die elektrische Anordnung herum - bevorzugt in dem Bereich, der auch durch die Abdeckung bedeckt wird -, und gegebenenfalls zusätzlich in einem Randbereich auf der elektronischen Anordnung.

Ein weiterer Gegenstand der Erfindung ist eine (opto-)elektronische Anordnung umfassend zumindest eine (opto-)elektronische Struktur und eine Schicht eines erfindungsgemäßen Klebstoffs, wobei die Klebstoffschicht die (opto-)elektronische Struktur vollflächig überdeckt.

Weitere Einzelheiten, Merkmale und Vorteile der vorliegenden Erfindung werden nachfolgend anhand bevorzugter Ausführungsbeispiele näher erläutert. In der Zeichnung zeigt

Abb. 3 eine (opto-)elektronische Anordnung nach dem Stand der Technik in schematischer Darstellung,

Abb. 4 eine erste erfindungsgemäße (opto-)elektronische Anordnung in schematischer Darstellung,

Abb. 5 eine zweite erfindungsgemäße (opto-)elektronische Anordnung in schematischer Darstellung.

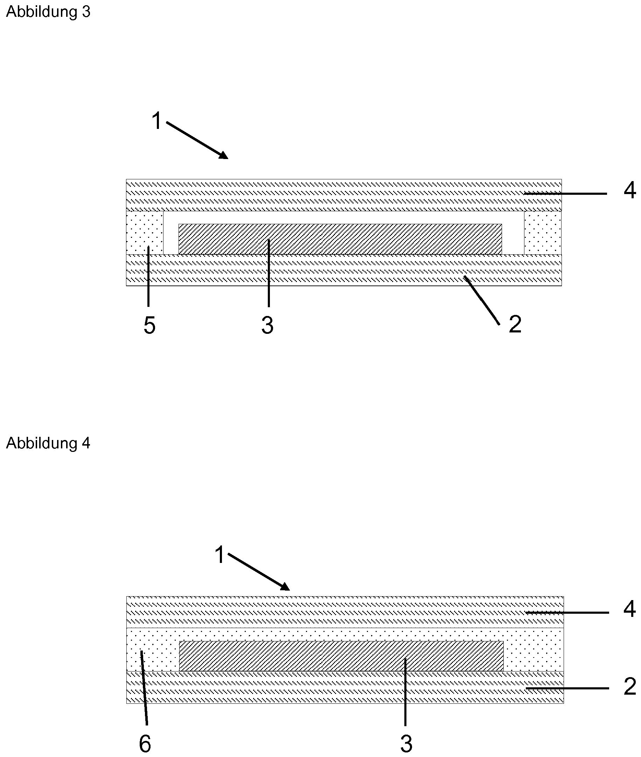

Abb. 3 zeigt eine erste Ausgestaltung einer organischen elektronischen Anordnung 1 nach dem Stand der Technik. Diese Anordnung 1 weist ein Substrat 2 auf, auf dem eine elektronische Struktur 3 angeordnet ist. Das Substrat 2 selbst ist als Barriere für Permeate ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist ein Klebstoff 5 umlaufend neben der elektronischen Struktur 3 auf dem Substrat 2 vorgesehen. Dabei ist es unerheblich, ob der Klebstoff zunächst mit dem Substrat 2 verbunden wurde oder zuerst mit der Abdeckung 4. Der Klebstoff 5 verbindet die Abdeckung 4 mit dem Substrat 2. Durch eine entsprechend dicke Ausgestaltung ermöglicht der Klebstoff 5 zudem die Beabstandung der Abdeckung 4 von der elektronischen Struktur 3.

Bei dem Klebstoff 5 handelt es sich um eine solche nach dem Stand der Technik, also einen Klebstoff mit hoher Permeationsbarriere, der zudem zu einem hohen Anteil mit Gettermaterial gefüllt sein kann. Die Transparenz des Klebstoffs ist in diesem Aufbau nicht relevant.

Ein Transferklebeband würde vorliegend in Form eines Stanzlings bereitgestellt, welcher aufgrund seiner filigranen Geometrie schwieriger handzuhaben ist als ein im Wesentlichen vollflächig appliziertes Transferklebeband.

Abb. 4 zeigt eine erfindungsgemäße Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun der erfindungsgemäße Klebstoff, zum Beispiel in der Ausführung als Transferklebeband 6 vollflächig angeordnet. Die elektronische Struktur 3 wird somit von oben vollständig durch das Transferklebeband 6 gekapselt. Auf das Transferklebeband 6 ist sodann eine Abdeckung 4 aufgebracht. Bei dem Transferklebeband 6 handelt es sich um ein solches auf Basis des erfindungsgemäßen Transferklebebands wie es vorstehend in allgemeiner Form beschrieben wurde und nachfolgend in Ausführungsbeispielen näher dargelegt ist. Das Transferklebeband besteht in der dargestellten Ausführung nur aus einer Schicht eines erfindungsgemäßen Klebstoffs.

Die Abdeckung 4 muss im Gegensatz zu der vorherigen Ausgestaltung nicht zwingend die hohen Barriereanforderungen erfüllen, da bei vollflächiger Überdeckung der elektronischen Anordnung durch das Transferklebeband die Barriere bereits durch den Klebstoff bereitgestellt wird. Die Abdeckung 4 kann beispielsweise lediglich eine mechanische Schutzfunktion wahrnehmen, sie kann aber auch zusätzlich als Permeationsbarriere vorgesehen sein.

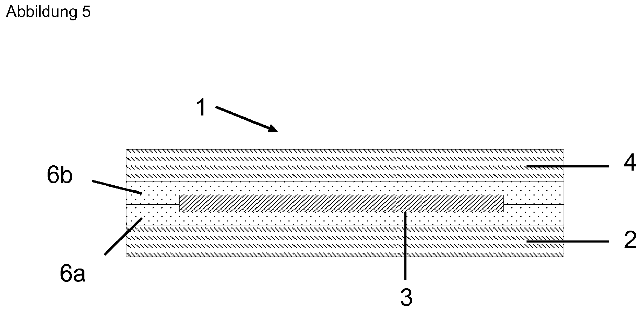

Abb. 5 zeigt eine alternative Ausgestaltung einer (opto-)elektronischen Anordnung 1. Im Gegensatz zu den vorherigen Ausgestaltungen sind nun zwei Transferklebebänder 6a, b vorgesehen, die vorliegend identisch ausgebildet sind, aber auch unterschiedlich sein können. Das erste Transferklebeband 6a ist vollflächig auf dem Substrat 2 angeordnet. Auf dem Transferklebeband 6a ist die elektronische Struktur 3 vorgesehen, die durch das Transferklebeband 6a fixiert wird. Der Verbund aus Transferklebeband 6a und elektronischer Struktur 3 wird dann mit dem weiteren Transferklebeband 6b vollflächig überdeckt, so dass die elektronische Struktur 3 von allen Seiten durch die Transferklebebänder 6a, b gekapselt ist. Oberhalb des Transferklebebands 6b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeaten zur elektronischen Struktur 3 weiter einzuschränken.

Insbesondere im Hinblick auf die Abb. 4 und 5 wird darauf hingewiesen, dass es sich vorliegend um schematische Darstellungen handelt. Aus den Darstellungen ist insbesondere nicht ersichtlich, dass das Transferklebeband hier und vorzugsweise jeweils eine homogene Schichtdicke aufweist. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum durchgeführt wird. Zudem wird die Klebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Auch ist ein direkter Kontakt des Klebstoffs mit dem elektronischen Aufbau nicht zwingend vorzusehen. Es können auch weitere Schichten dazwischen angeordnet sein wie zum Beispiel eine Dünnschichtverkapselung des elektronischen Aufbaus oder Barrierefilme.

Die Dicke des Transferklebebands kann alle üblichen Dicken umfassen, also etwa von 1 µm bis zu 3000 µm. Bevorzugt wird eine Dicke zwischen 25 und 100 µm, da in diesem Bereich Klebkraft und Handlingeigenschaften besonders positiv ausfallen. Ein weiterer bevorzugter Bereich ist eine Dicke von 3 bis 25 µm, da in diesem Bereich die Menge von durch die Klebefuge permeierenden Stoffen allein durch die kleine Querschnittsfläche der Klebefuge in einer Verkapselungsanwendung gering gehalten werden kann.

Zur Herstellung eines erfindungsgemäßen Transferklebebands wird der Träger des Klebebands oder der Liner einseitig mit dem erfindungsgemäßen Klebstoff aus Lösung oder Dispersion oder 100 %ig (zum Beispiel Schmelze) beschichtet oder bedruckt, oder das Klebeband wird durch (Co-)Extrusion hergestellt. Alternativ ist eine Herstellung durch Transfer einer erfindungsgemäßen Klebstoff-Schicht durch Kaschieren auf eine Trägermaterial oder einen Liner möglich. Die Klebestoffschicht kann durch Wärme oder energiereiche Strahlen vernetzt werden.

Bevorzugt findet dieser Herstellprozess in einer Umgebung statt, in der das spezifische Permeat nur in geringer Konzentration oder nahezu gar nicht enthalten ist. Als Beispiel kann eine relative Luftfeuchtigkeit von weniger als 30 %, bevorzugt von weniger als 15 % genannt werden.

### Beispiele

### Messmethoden

### Bestimmung der Durchbruchzeit (Lebensdauertest)

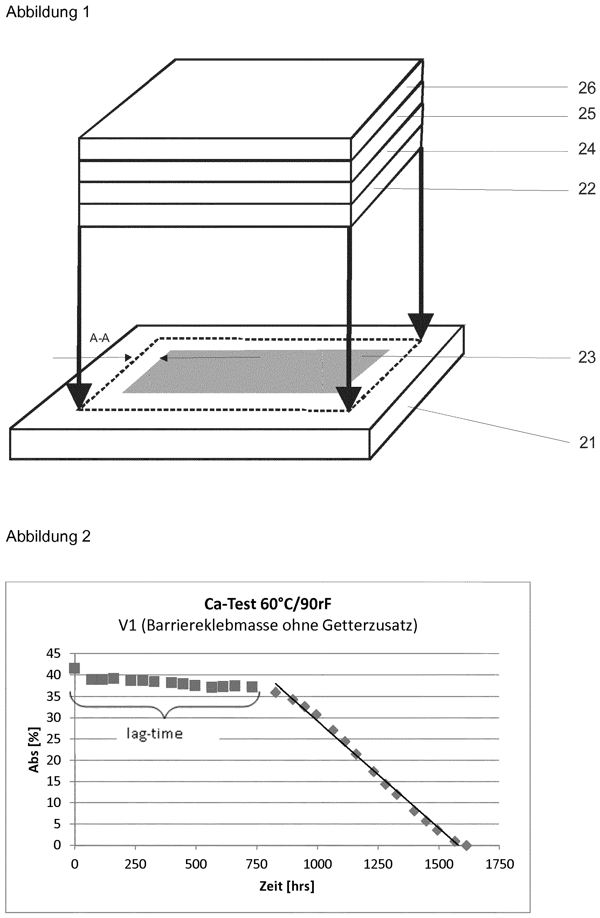

Als ein Maß für die Bestimmung der Lebensdauer eines elektronischen Aufbaus wurde ein Calciumtest herangezogen. Dieser ist in der Abbildung 1 gezeigt. Dazu wird im Vakuum eine 10 × 10 mm² große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (23 × 23 mm²) mit der zu testenden Klebemasse 22 sowie einer Dünnglasscheibe 24 (35 µm, Firma Schott) als Trägermaterial verwendet. Zur Stabilisierung war die Dünnglasscheibe mit einer 100 µm dicken PET-Folie 26 mittels eines 50 µm dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 6,5 mm (A-A) abdeckt. Aufgrund des undurchlässigen Glasträgers 24 wird nur die Permeation durch den Haftkleber oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet. Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 60 °C und 90 % relative Luftfeuchte gewählt. Die Muster wurden mit einer Schichtdicke der Haftklebemasse von 50 µm vollflächig und blasenfrei verklebt. Der Abbau des Ca-Spiegels wird über Transmissionsmessungen verfolgt. Die Durchbruchzeit (lag-time) ist definiert als diejenige Zeit, die Feuchtigkeit benötigt, um die Strecke bis zum Ca zurückzulegen (vgl. Abb.2). Bis zum Erreichen dieser Zeit bei 60°C 90% r.F. ändert sich die Transmission des Ca-Spiegels nur marginal und bei 85°C 85% r.F. ein wenig.

### Permeabilität für Wasserdampf

Die Bestimmung der Permeabilität für Wasserdampf (WVTR) erfolgt nach ASTM F-1249. Die Haftklebemasse wird dazu mit einer Schichtdicke von 50 µm auf eine hochpermeable Polysulfon-Membran (erhältlich von der Firma Sartorius) aufgebracht, die selbst keinen Beitrag zur Permeationsbarriere liefert. Die Wasserdampfdurchlässigkeit wird bei 37,5 °C und einer relativen Feuchte von 90 % mit einem Messgerät Mocon OX-Tran 2/21 bestimmt.

### Molekulargewicht

Die Molekulargewichtsbestimmungen der zahlenmittleren Molekulargewichte Mₙ und der gewichtsmittleren Molekulargewichte M_{w} erfolgten mittels Gelpermeationschromatographie (GPC). Als Eluent wurde THF (Tetrahydrofuran) mit 0,1 Vol.-% Trifluoressigsäure eingesetzt. Die Messung erfolgte bei 25 °C. Als Vorsäule wurde PSS-SDV, 5 µ, 10³ Å, ID 8,0 mm × 50 mm verwendet. Zur Auftrennung wurden die Säulen PSS-SDV, 5 µ, 10³ sowie 10⁵ und 10⁶ mit jeweils ID 8,0 mm x 300 mm eingesetzt. Die Probenkonzentration betrug 4 g/l, die Durchflussmenge 1,0 ml pro Minute. Es wurde gegen Polystyrol-Standards gemessen.

### MMAP und DACP

MMAP ist der gemischte-Methylcyclohexan-Anilin-Trübungspunkt, der unter Verwendung eines modifizierten ASTM C 611-Verfahrens bestimmt wird. Methylcyclohexan ist für das in dem Standard-Prüfverfahren verwendete Heptan eingesetzt. Das Verfahren verwendet Harz/Anilin/Methylcyclohexan in einem Verhältnis von 1/2/1 (5 g/10 ml/5 ml) und der Trübungspunkt wird durch Abkühlen einer erhitzten, klaren Mischung der drei Komponenten, bis die vollständige Trübung gerade eintritt, bestimmt

Der DACP ist der Diaceton-Trübungspunkt und wird durch Abkühlen einer erhitzten Lösung von 5 g Harz, 5 g Xylol und 5 g Diacetonalkohol bis zu dem Punkt bestimmt, bei welchem die Lösung trübe wird.

### Ring & Ball-Erweichungstemperatur:

Die Klebharzerweichungstemperatur wird nach der einschlägigen Methodik durchgeführt, die als Ring and Ball bekannt ist und nach ASTM E28 standardisiert ist.

Zur Bestimmung der Klebharzerweichungstemperatur der Harze kommt ein Ring-Kugel-Automat HRB 754 der Firma Herzog zum Einsatz. Harzmuster werden zunächst fein gemörsert. Das resultierende Pulver wird in einen Messingzylinder mit Bodenöffnung (Innendurchmesser am oberen Teil des Zylinders 20 mm, Durchmesser der Bodenöffnung des Zylinders 16 mm, Höhe des Zylinders 6 mm) gefüllt und auf einem Heiztisch geschmolzen. Die Befüllmenge wird so gewählt, dass das Harz nach dem Schmelzen den Zylinder ohne Überstand voll ausfüllt.

Der resultierende Probekörper wird samt Zylinder in die Probehalterung des HRB 754 eingelegt. Zur Befüllung des Temperierbads wird Glycerin verwendet, sofern die Klebharzerweichungstemperatur zwischen 50 °C und 150 °C liegt. Bei niedrigeren Klebharzerweichungstemperaturen kann auch mit einem Wasserbad gearbeitet werden. Die Prüfkugeln haben einen Durchmesser von 9,5 mm und wiegen 3,5 g. Entsprechend der HRB 754 Prozedur wird die Kugel oberhalb des Probekörpers im Temperierbad angeordnet und auf dem Probekörper abgelegt. 25 mm unter dem Zylinderboden befindet sich eine Auffangplatte, 2 mm über dieser eine Lichtschranke. Während des Messvorgangs wird die Temperatur mit 5 °C/min erhöht. Im Temperaturbereich der Klebharzerweichungstemperatur beginnt sich die Kugel durch die Bodenöffnung des Zylinders zu bewegen, bis sie schließlich auf der Auffangplatte zum Stehen kommt. In dieser Position wird sie von der Lichtschranke detektiert und zu diesem Zeitpunkt die Temperatur des Temperierbads registriert. Es findet eine Doppelbestimmung statt. Die Klebharzerweichungstemperatur ist der Mittelwert aus den beiden Einzelmessungen.

### Klebemassenschichten:

Zur Herstellung von Klebemasseschichten wurden verschiedene Klebemassen aus einer Lösung auf einen konventionellen Liner (silikonisierte Polyesterfolie) mittels eines Laborstreichgeräts aufgebracht und getrocknet. Die Klebemassenschichtdicke nach dem Trocknen beträgt 50±5 µm. Die Trocknung erfolgte jeweils zunächst bei RT für 10 Minuten und 10 Minuten bei 120 °C in einem Labortrockenschrank. Die getrockneten Klebemasseschichten wurden jeweils unverzüglich nach dem Trocknen mit einem zweiten Liner (silikonisierte Polyesterfolie mit geringerer Trennkraft) auf der offenen Seite laminiert.

### Verwendete Rohstoffe:

| | |
|---|---|
| Sibstar 62M | SiBS (Polystyrol-block-Polyisobutylen-Blockcopolymer) der Firma Kaneka mit 20 Gew.-% Blockpolystyrolgehalt. Enthält zum Teil auch Diblockcopolymere. |
| | |
| Tuftec P 1500 | SBBS mit 30 % Blockpolystyrolgehalt der Firma Asahi Das SBBS enthielt ca. 68% Zweiblockgehalt. |
| HBE-100 | hydrierter Bisphenol A diglycidylether der Firma ECEM |
| Escorez 5300 | ein vollhydriertes Kohlenwasserstoffharz der Firma Exxon. (Ring and Ball 105 °C, DACP = 71, MMAP = 72) |
| Escorez 5600 | Hydriertes KW-Harz mit einem Erweichungspunkt von 100°C der Firma Exxon. |
| Ondina G 17 | Weißöl aus parafinischen und naphtenischen Anteilen der Firma Shell |
| Polyacrylat | Acrylatcopolymer aus 2-Hydroxyethylacrylat, 2 Ethyl-hexylacrylat und C-17-Acrylat, Mₙ = 884000 g / mol |
| Glycidoxypropyltriethoxysilan [4-(2-hydroxytetradecyloxy)phe- nyl] phenyliodonium hexafluoroantimonat | Triethoxysilan mit Glycidylepoxidgruppe kationischer Fotoinitiator von der Firma Sigma-Aldrich Der Photoinitiator weist ein Absorptionsmaximum im Bereich 320 nm bis 360 nm auf und lag als 50 Gew.-%-ige Lösung in Propylencarbonat vor |
| Titan(IV) isopropoxid | Katalysator für die Hydrolyse von Alkoxysilanen (Sigma-Aldrich) |

Als Copolymer wurde ein Polystyrol-block-Polyisobutylen Blockcopolymer der Firma Kaneka ausgewählt. Der Anteil an Styrol im Gesamtpolymer beträgt 20 Gew.-%. Es wurde Sibstar 62M verwendet. Die Molmasse M_{w} beträgt 60.000 g/mol. Die Glasübergangstemperatur der Polystyrolblöcke betrug 100 °C und der Polyisobutylenblöcke -60 °C. Als Klebharz kam Escorez 5300 (Ring and Ball 105 °C, DACP = 71, MMAP = 72) der Firma Exxon, ein vollhydriertes Kohlenwasserstoffharz, beziehungsweise Escorez 5600 (Erweichungspunkt 100°C), ein hydriertes Kohlenwasserstoffharz, zum Einsatz. Diese Rohstoffe sowie ggf. das Alkoxysilan wurden in einem Gemisch aus Toluol (300 g), Aceton (150 g) und Siedegrenzenbenzin 60/95 (550 g) gelöst, so dass eine 50 Gew.-% Lösung entsteht.

Anschließend wurde der Lösung ein Katalysator zugesetzt. Der Katalysator lag als 50 Gew.-%ige Lösung in Propylencarbonat vor. Der photolatente Katalysator weist ein Absorptionsmaximum im Bereich 320 nm bis 360 nm auf.

Die genaue Zusammensetzung der einzelnen Beispiele V1 und V2 beziehungsweise K1 und K2 ist der Tabelle 1 zu entnehmen.

**Tabelle 1:**

| **Beispiel:** | **K1** | **K2** | **V1** | **V2** |
|---|---|---|---|---|
| | Gew.-Teile | Gew.-Teile | Gew.-Teile | Gew.-Teile |
| Sibstar 62M | | 37,5 | | |
| HBE-100 | | 20 | | 20 |
| Escorez 5600 | 100 | | 100 | |
| Escorez 5300 | | 37,5 | | |
| Ondina G17 | 25 | | 25 | |
| Tuftec P 1500 | 100 | | 100 | |
| Polyacrylat | | | - | 75 |
| Glycidoxypropyltri-ethoxysilan | | 5 | | |
| Triethoxyoctylsilan | 10 | | | 5 |
| Titanium(IV) isopropoxide | | | 0,3 | |
| [4-(2-hydroxytetradecyloxy)phenyl] phenyliodonium hexafluoroantimonat | 0,3 | 0,1 | | 0,1 |

Die Muster wurden in eine Glove-Box eingeschleust. Ein Teil der Muster wurde auf einem mit Ca bedampften Glassubstrat mit einem Gummianroller blasenfrei laminiert. Darauf wurde der zweite PET-Liner ausgedeckt und eine Lage eines Dünnglases auflaminiert. Dieses Muster wurde für den Lebensdauertest verwendet.

Die Ergebnisse der Feuchtigkeitspermeationsmessung der Massen sowie die ermittelten Durchbruchzeiten von Wasser im Ca-Test vor und nach der Aktivierung des Katalysators und damit des Getters sowie nachdem die Proben Wasser ausgesetzt waren, sind in Tabelle 2 wiedergegeben.

**Tabelle 2:**

| | **K1** | **K2** | **V1** | **V2** |
|---|---|---|---|---|
| **WVTR / g m⁻²d⁻¹** | 33 | 12 | 34 | 678 |
| **lag-time¹/ h** | 10 | 0 | 150 | 0 |
| **lag-time²/ h** | 150 | 470 | 150 | 0 |
| **lag-time³/ h** | 145 | 480 | 0 | 0 |

| | | | | |
|---|---|---|---|---|
| ¹: Frisches Klebeband, (Katalysator nicht durch UV-Licht aktiviert), Ca-Test bei 60°C / 90% rF ²: Frisches Klebeband, Aktivierung des Katalysators mit UV-Licht, Ca-Test bei 60°C / 90% rF ³: nachdem die Probe 1 Tag bei 23°C / 50%rF H₂O ausgesetzt war, erneutes Trocknen in inerter Atmosphäre, Aktivierung des Katalysators mit UV-Licht. Ca-Test bei 60°C / 90% rF | | | | |

Für Vergleichsbeispiel V1 wurde ein nicht erfindungsgemäßer, das heißt ein nicht schaltbarer Katalysator verwendet. Die Probe weist eine gewisse lag-time auf, die sich durch Bestrahlung mit UV-Licht nicht verändert. Der Getter ist nicht schaltbar. Bei dem erfindungsgemäßen Beispiel K1 verändert sich die lag-time signifikant. Im Beispiel K1 ist die lag-time nach der Aktivierung des Katalysators und damit des Getters durch UV-Strahlung 15 Mal höher als vor der Aktivierung. K2 ist ein Beispiel für eine kombinierte Aktivierung des Getters und Aushärtung des Reaktivharzes. Vor Aktivierung/Aushärtung weist die Klebemasse keine lag-time auf. Durch die Aktivierung/Aushärtung wird eine große lag-time erreicht.

Als die nicht-aktivierten Proben einen Tag feuchter Luft ausgesetzt waren, zeigt die nichterfindungsgemäße Probe V1, dass der Getter verbraucht wurde und mit dem Wasser bereits reagiert hatte, so dass die lag-time auf null abgesunken ist. Bei den erfindungsgemäßen Proben K1 und K2 hingegen hatte der nicht-aktivierte Getter während des einen Tages nicht mit dem in der feuchten Luft enthaltenen Wasser reagiert. Die lag-time der Proben war im Wesentlichen identisch zu derjenigen einer Probe, die nicht feuchter Luft ausgesetzt war. Obwohl die Proben also Wasserdampf ausgesetzt waren, hatte dies keinen Einfluss auf ihre Wirksamkeit als Getter, da die Getterfunktion noch nicht aktiviert gewesen war.

Vergleichsbeispiel V2 zeigt, dass eine Probe mit einem hohen WVTR-Wert keine messbare lag-time aufweist.

## Patentansprüche

1. Klebemasse, wobei die Klebemasse eine Barriereklebemasse ist, deren Klebstoffbasis im Falle des Vorhandenseins eines Reaktivharzes nach dessen Aushärtung, eine Wasserdampfpermeationsrate von weniger als 100 g/m²d aufweist, bestimmt gemäß ASTM F-1249 bei 37,5 °C und einer relativen Feuchte von 90%,, enthaltend
ein Gettermaterial sowie
optional ein Lösungsmittel,
**dadurch gekennzeichnet, dass** die Klebemasse einen Katalysator für die Reaktion des Gettermaterials mit einem Permeaten enthält, der mittels eines äußeren Stimulus aktivierbar ist, wobei das Gettermaterial mindestens eine Verbindung ausgewählt aus der Gruppe umfassend Ethoxysilane ist und wobei das Permeat Wasser ist.

2. Klebemasse nach Anspruch 1, **dadurch gekennzeichnet, dass** der Getter in einer Menge von mindestens 2 Gew.-%, bevorzugt mindestens 3 Gew.-%, insbesondere mindestens 5 Gew.-% enthalten ist.

3. Klebemasse nach zumindest einem der Ansprüche 1 bis 2, **dadurch gekennzeichnet, dass** die Menge an Katalysator weniger als 5 Gew.-%, bevorzugt weniger als 2 Gew.-%, insbesondere weniger als 1 Gew.-% beträgt.

4. Klebemasse nach zumindest einem der Ansprüche 1 bis 3, **dadurch gekennzeichnet, dass** der äußere Stimulus UV-Strahlung, eine Temperaturveränderung, Mikrowellenstrahlung oder sichtbares Licht ist.

5. Klebemasse nach zumindest einem der Ansprüche 1 bis 4, **dadurch gekennzeichnet, dass** der durch einen äußeren Stimulus aktivierbare Katalysator eine latente Säure oder eine latente Base ist.

6. Klebemasse nach zumindest einem der Ansprüche 1 bis 5, **dadurch gekennzeichnet, dass** die Klebemasse eine Klebstoffbasis aus
- mindestens einem Polymer, insbesondere Elastomer und
- mindestens einem Klebharz umfasst.

7. Klebemasse nach zumindest einem der Ansprüche 1 bis 6, **dadurch gekennzeichnet, dass** die Klebstoffbasis des Weiteren mindestens ein Reaktivharz mit mindestens einer härtbaren Gruppe enthält.

8. Klebemasse nach Anspruch 6 oder 7, **dadurch gekennzeichnet, dass** die Klebstoffbasis sofern ein Reaktivharz vorhanden ist, nach dessen Aushärtung eine Wasserdampfpermeationsrate von weniger als 50 g/m²d, insbesondere weniger als 15 g/m²d aufweist.

9. Klebemasse nach Anspruch 9, **dadurch gekennzeichnet, dass** das Ethoxysilan zusätzlich mindestens eine polymerisierbare Gruppe enthält.

10. Klebemasse nach Anspruch 9, **dadurch gekennzeichnet, dass** die polymerisierbare Gruppe mit denen des optionalen Reaktivharzes polymerisierbar ist, insbesondere **dadurch gekennzeichnet, dass** die polymerisierbare Gruppe die gleiche wie die des Reaktivharzes ist.

11. Klebemasse nach Anspruch 7, **dadurch gekennzeichnet, dass** die mindestens eine härtbare Gruppe mindestens eine Gruppe ausgewählt aus cyclischem Ether, Vinyl, Acrylat, Methacrylat, Hydroxyl, Amino und Isocyanat ist.

12. Klebemasse nach zumindest einem der Ansprüche 1 bis 11, **dadurch gekennzeichnet, dass** die Klebemasse haftklebrig ist.

13. Klebeband enthaltend eine Klebemasse nach einem der Ansprüche 1 bis 12.

14. Verwendung der Klebemasse nach einem der Ansprüche 1 bis 12 oder des Klebebandes nach Anspruch 13 zur Verkapselung von Aufbauten in der organischen Elektronik.

15. Verfahren zum Applizieren einer Klebemasse nach einem der Ansprüche 1 bis 12, oder eines Klebebandes nach Anspruch 13 umfassend die Schritte
- Aufbringen der Klebemasse oder des Klebebandes auf den zu verklebenden Gegenstand;
- Aktivieren des Gettermaterials mittels eines äußeren Stimulus.

16. Verfahren nach Anspruch 15, **dadurch gekennzeichnet, dass** die Klebemasse ein Reaktivharz enthält und durch den äußeren Stimulus neben dem Aktivieren des Gettermaterials auch das Aushärten der Klebemasse oder des Klebebandes induziert werden.

17. Verfahren zum Schutz einer auf einem Substrat angeordneten organischen elektronischen Anordnung,
wobei eine Abdeckung derart auf die elektronische Anordnung aufgebracht wird, dass die elektronische Anordnung zumindest teilweise durch die Abdeckung überdeckt wird,
wobei weiterhin die Abdeckung zumindest teilflächig auf dem Substrat und/oder auf der elektronischen Anordnung verklebt wird,
wobei die Verklebung mittels zumindest einer Schicht einer Klebemasse nach zumindest einem der vorherigen Ansprüche bewirkt wird.

18. Verfahren nach Anspruch 17,
**dadurch gekennzeichnet, dass**
die Klebemasse als Schicht eines Klebebands vorliegt.

19. Verfahren nach zumindest einem der Ansprüche 17 oder 18,
**dadurch gekennzeichnet, dass**
zunächst die Klebemasseschicht, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird.

20. Verfahren nach zumindest einem der Ansprüche 17 bis 19,
**dadurch gekennzeichnet, dass**
die Klebemasseschicht und die Abdeckung gemeinsam auf das Substrat und/oder die elektronische Anordnung aufgebracht werden.

21. Verfahren nach zumindest einem der Ansprüche 17 bis 20,
**dadurch gekennzeichnet, dass**
die Abdeckung die elektronische Anordnung vollständig überdeckt.

22. Verfahren nach zumindest einem der Ansprüche 17 bis 20,
**dadurch gekennzeichnet, dass**
auch ein Bereich des Substrats um die elektronische Anordnung herum durch die Abdeckung ganz oder teilweise überdeckt wird.

## Claims

1. Adhesive, where the adhesive is a barrier adhesive, the adhesive base of which, in the presence of a reactive resin after curing thereof, has a water vapour permeation rate of less than 100 g/m²d, determined to ASTM F-1249 at 37.5°C and a relative humidity of 90%, comprising
a getter material and
optionally a solvent,
**characterized in that** the adhesive comprises a catalyst for the reaction of the getter material with a permeate, which is activatable by means of an external stimulus, where the getter material is at least one compound selected from the group comprising ethoxysilanes and where the permeate is water.

2. Adhesive according to Claim 1, **characterized in that** the getter is present in an amount of at least 2% by weight, preferably at least 3% by weight, especially at least 5% by weight.

3. Adhesive according to at least one of Claims 1 and 2, **characterized in that** the amount of catalyst is less than 5% by weight, preferably less than 2% by weight, especially less than 1% by weight.

4. Adhesive according to at least one of Claims 1 to 3, **characterized in that** the external stimulus is UV radiation, a temperature change, microwave radiation or visible light.

5. Adhesive according to at least one of Claims 1 to 4, **characterized in that** the catalyst activatable by an external stimulus is a latent acid or a latent base.

6. Adhesive according to at least one of Claims 1 to 5, **characterized in that** the adhesive comprises an adhesive base composed of
- at least one polymer, especially elastomer, and
- at least one tackifying resin.

7. Adhesive according to at least one of Claims 1 to 6, **characterized in that** the adhesive base further comprises at least one reactive resin having at least one curable group.

8. Adhesive according to Claim 6 or 7, **characterized in that** the adhesive base, if a reactive resin is present, has a water vapour permeation rate after curing of less than 50 g/m²d, especially less than 15 g/m²d.

9. Adhesive according to Claim 9, **characterized in that** the ethoxysilane additionally comprises at least one polymerizable group.

10. Adhesive according to Claim 9, **characterized in that** the polymerizable group is polymerizable with those of the optional reactive resin, especially **characterized in that** the polymerizable group is the same as that in the reactive resin.

11. Adhesive according to Claim 7, **characterized in that** the at least one curable group is at least one group selected from cyclic ether, vinyl, acrylate, methacrylate, hydroxyl, amino and isocyanate.

12. Adhesive according to at least one of Claims 1 to 11, **characterized in that** the adhesive is a pressure-sensitive adhesive.

13. Adhesive tape comprising an adhesive according to any of Claims 1 to 12.

14. Use of the adhesive according to any of Claims 1 to 12 or of the adhesive tape according to Claim 13 for encapsulation of assemblies in organic electronics.

15. Method for applying an adhesive according to any of Claims 1 to 12, or an adhesive tape according to Claim 13, comprising the steps of
- applying the adhesive or the adhesive tape to the article to be bonded;
- activating the getter material by means of an external stimulus.

16. Method according to Claim 15, **characterized in that** the adhesive comprises a reactive resin and the external stimulus induces not only the activation of the getter material but also the curing of the adhesive or the adhesive tape.

17. Method for protecting an organic electronic arrangement disposed on a substrate,
wherein a cover is applied to the electronic arrangement in such a way
that the electronic arrangement is at least partly covered by the cover,
wherein the cover is additionally bonded over at least part of the area on the substrate and/or on the electronic arrangement,
wherein the bonding is brought about by means of at least one layer of an adhesive according to at least one of the preceding claims.

18. Method according to Claim 17,
**characterized in that**
the adhesive takes the form of a layer of an adhesive tape.

19. Method according to at least one of Claims 17 and 18,
**characterized in that**
the adhesive layer, optionally as a constituent of a double-sided adhesive tape comprising further layers, is applied first, and in a subsequent step the cover is applied to the substrate and/or the electronic arrangement.

20. Method according to at least one of Claims 17 to 19,
**characterized in that**
the adhesive layer and the cover are applied together to the substrate and/or the electronic arrangement.

21. Method according to at least one of Claims 17 to 20,
**characterized in that**
the cover fully covers the electronic arrangement.

22. Method according to at least one of Claims 17 to 20,
**characterized in that**
a region of the substrate around the electronic arrangement is also wholly or partly covered by the cover.

## Revendications

1. Masse adhésive, la masse adhésive étant une masse adhésive barrière dont la base adhésive, en cas de présence d'une résine réactive, présente après son durcissement un taux de perméation de la vapeur d'eau inférieur à 100 g/m²d, déterminé selon la norme ASTM F-1249 à 37,5 °C et une humidité relative de 90 %, contenant
un matériau getter ainsi que
en option, un solvant,
**caractérisée en ce que** la masse adhésive contient un catalyseur pour la réaction du matériau getter avec un perméat qui peut être activé au moyen d'un stimulus externe, le matériau getter étant au moins un composé choisi dans le groupe comprenant les éthoxysilanes et le perméat étant l'eau.

2. Masse adhésive selon la revendication 1, **caractérisée en ce que** le getter est contenu en une quantité d'au moins 2 % en poids, de préférence d'au moins 3 % en poids, notamment d'au moins 5 % en poids.

3. Masse adhésive selon au moins l'une quelconque des revendications 1 à 2, **caractérisée en ce que** la quantité de catalyseur est inférieure à 5 % en poids, de préférence inférieure à 2 % en poids, notamment inférieure à 1 % en poids.

4. Masse adhésive selon au moins l'une quelconque des revendications 1 à 3, **caractérisée en ce que** le stimulus externe est un rayonnement UV, un changement de température, un rayonnement micro-ondes ou une lumière visible.

5. Masse adhésive selon au moins l'une quelconque des revendications 1 à 4, **caractérisée en ce que** le catalyseur activable par un stimulus externe est un acide latent ou une base latente.

6. Masse adhésive selon au moins l'une quelconque des revendications 1 à 5, **caractérisée en ce que** la masse adhésive comprend une base adhésive
- d'au moins un polymère, notamment un élastomère, et
- d'au moins une résine adhésive.

7. Masse adhésive selon au moins l'une quelconque des revendications 1 à 6, **caractérisée en ce que** la base adhésive contient en outre au moins une résine réactive ayant au moins un groupe durcissable.

8. Masse adhésive selon la revendication 6 ou 7, **caractérisée en ce que** la base adhésive, si une résine réactive est présente, présente après son durcissement un taux de perméation de la vapeur d'eau inférieur à 50 g/m²d, notamment inférieur à 15 g/m²d.

9. Masse adhésive selon la revendication 9, **caractérisée en ce que** l'éthoxysilane contient en outre au moins un groupe polymérisable.

10. Masse adhésive selon la revendication 9, **caractérisée en ce que** le groupe polymérisable est polymérisable avec ceux de la résine réactive optionnelle, notamment **caractérisée en ce que** le groupe polymérisable est le même que celui de la résine réactive.

11. Masse adhésive selon la revendication 7, **caractérisée en ce que** l'au moins un groupe durcissable est au moins un groupe choisi parmi un éther cyclique, un vinyle, un acrylate, un méthacrylate, un hydroxyle, un amino et un isocyanate.

12. Masse adhésive selon au moins l'une quelconque des revendications 1 à 11, **caractérisée en ce que** la masse adhésive est auto-adhésive.

13. Ruban adhésif contenant une masse adhésive selon l'une quelconque des revendications 1 à 12.

14. Utilisation de la masse adhésive selon l'une quelconque des revendications 1 à 12 ou du ruban adhésif selon la revendication 13 pour l'encapsulation de structures dans l'électronique organique.

15. Procédé d'application d'une masse adhésive selon l'une quelconque des revendications 1 à 12, ou d'un ruban adhésif selon la revendication 13, comprenant les étapes suivantes :
- l'application de la masse adhésive ou du ruban adhésif sur l'objet à coller ;
- l'activation du matériau getter au moyen d'un stimulus externe.

16. Procédé selon la revendication 15, **caractérisé en ce que** la masse adhésive contient une résine réactive et **en ce que** le stimulus externe induit non seulement l'activation du matériau getter mais aussi le durcissement de la masse adhésive ou du ruban adhésif.

17. Procédé de protection d'un agencement électronique organique agencé sur un substrat,
un couvercle étant appliqué sur l'agencement électronique de telle sorte que
l'agencement électronique est au moins partiellement recouvert par le couvercle,
le couvercle étant en outre collé au moins sur une partie de sa surface sur le substrat et/ou sur l'agencement électronique,
le collage étant effectué au moyen d'au moins une couche d'une masse adhésive selon au moins l'une quelconque des revendications précédentes.

18. Procédé selon la revendication 17,
**caractérisé en ce que**
la masse adhésive se présente sous la forme d'une couche d'un ruban adhésif.

19. Procédé selon au moins l'une quelconque des revendications 17 ou 18,
**caractérisé en ce que**
la couche de masse adhésive est tout d'abord appliquée, éventuellement en tant que constituant d'un ruban adhésif double face comprenant d'autres couches, et, dans une étape suivante, le couvercle est appliqué sur le substrat et/ou l'agencement électronique.

20. Procédé selon au moins l'une quelconque des revendications 17 à 19,
**caractérisé en ce que**
la couche de masse adhésive et le couvercle sont appliqués ensemble sur le substrat et/ou l'agencement électronique.

21. Procédé selon au moins l'une quelconque des revendications 17 à 20,
**caractérisé en ce que**
le couvercle recouvre entièrement l'agencement électronique.

22. Procédé selon au moins l'une quelconque des revendications 17 à 20,
**caractérisé en ce que**
également une zone du substrat autour de l'agencement électronique est entièrement ou partiellement recouverte par le couvercle.
